(19) Europäisches Patentamt
European Patent Office
Office européen des brevets

(11) **EP 4 693 913 A1**

(12) **EUROPEAN PATENT APPLICATION**
published in accordance with Art. 153(4) EPC

(43) Date of publication:
**11.02.2026 Bulletin 2026/07**

(21) Application number: **24822310.9**

(22) Date of filing: **14.03.2024**

(51) International Patent Classification (IPC):
**H04B 1/401** (2015.01)

(52) Cooperative Patent Classification (CPC):
**H04B 1/00; H04B 1/38; H04B 1/401**

(86) International application number:
**PCT/CN2024/081551**

(87) International publication number:
**WO 2024/255352 (19.12.2024 Gazette 2024/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.06.2023 CN 202310724481**

(71) Applicant: **Honor Device Co., Ltd.
Shenzhen, Guangdong 518040 (CN)**

(72) Inventor: **ZHANG, Ziyan
Shenzhen, Guangdong 518040 (CN)**

(74) Representative: **Gill Jennings & Every LLP
The Broadgate Tower
20 Primrose Street
London EC2A 2ES (GB)**

(54) **MULTI-PORT CONNECTING CIRCUIT, RADIO FREQUENCY FRONT-END MODULE, AND ELECTRONIC DEVICE**

(57) The disclosure relates to the technical field of radio frequency circuits, and provides a multi-port connection circuit, a radio frequency front-end module, and an electronic device. The multi-port connection circuit includes: a first switch, a second switch, a first branch transmission line, a second branch transmission line, and a first common transmission line. A first end of the first switch and a second end of the first switch are two ends that are capable of being connected. A first end of the second switch and a second end of the second switch are two ends that are capable of being connected. The second end of the first switch is connected to a first end of the first branch transmission line. The second end of the second switch is connected to a first end of the second branch transmission line. A second end of the first branch transmission line and a second end of the second branch transmission line are both directly connected to a first end of the first common transmission line. The circuit can reduce insertion loss on a signal path.

FIG. 3

EP 4 693 913 A1

**Description**

The disclosure claims priority to Chinese Patent Application No. 202310724481.X, filed with the China National Intellectual Property Administration on June 16, 2023 and entitled "Multi-port connection circuit, radio frequency front-end module, and electronic device", which is incorporated herein by reference in its entirety.

**TECHNICAL FIELD**

The disclosure relates to the technical field of radio frequency circuits, and particularly relates to a multi-port connection circuit, a radio frequency front-end module, and an electronic device.

**BACKGROUND**

With development of communications technologies, increasing requirements have been imposed on functions and performance of a terminal device, and higher specifications need to be supported by the terminal device. For example, the terminal device needs to support more frequency bands and have more antennas to adapt to more communication scenes.

Generally, more radio frequency channels are added to a radio frequency front-end module of the terminal device, so as to expand a frequency band. However, because of limited space of the terminal device, unlimited increase in the number of antennas to adapt to expansion of the radio frequency channels is impossible. Thus, a plurality of radio frequency channels generally share one antenna, so as to reduce the number of antennas. In this way, in a case with a limited number of antennas and a large number of radio frequency channels, a complex switching scene of each radio frequency channel in the radio frequency front-end module is caused. To address a complex scene of radio frequency channel switching, a conventional method is to increase the number of switches or use switches having more ports, to satisfy demands of the complex switching scene.

However, increase in the number of switches or use of the switches having more ports will lead to an increase in insertion loss of a single radio frequency channel, as well as an increase in power consumption of the terminal device.

**SUMMARY**

The disclosure provides a multi-port connection circuit, a radio frequency front-end module, and an electronic device, so as to ensure low insertion loss of a signal path and reduce power consumption.

A first aspect provides a multi-port connection circuit. The multi-port connection circuit includes: a first switch, a second switch, a first branch transmission line, a second branch transmission line, and a first common transmission line. A first end of the first switch and a second end of the first switch are two ends that are capable of being connected. A first end of the second switch and a second end of the second switch are two ends that are capable of being connected. The second end of the first switch is connected to a first end of the first branch transmission line. The second end of the second switch is connected to a first end of the second branch transmission line. A second end of the first branch transmission line and a second end of the second branch transmission line are both directly connected to a first end of the first common transmission line. When the first end of the first switch and the second end of the first switch are connected and the second end of the second switch is disconnected, the first end of the first switch and a second end of the first common transmission line are in an impedance matching state in a first frequency band, and the first end of the second switch is in a high-impedance state in the first frequency band.

In the multi-port connection circuit, a second end of the first transmission line and a second end of the second branch transmission line are both directly connected to a first end of the first common transmission line. When the first end of the first switch and the second end of the first switch are connected and the second end of the second switch is disconnected, the first end of the first switch and a second end of the first common transmission line are in an impedance matching state in a first frequency band, such that a signal of the first frequency band may be transmitted with low loss. In a case without influencing normal transmission of the signal of the first frequency band, the first end of the second switch is in a high-impedance state in the first frequency band. For the signal of the first frequency band, an open circuit characteristic is achieved, such that the signal of the first frequency band fails to pass, and frequency gating is implemented. In the multi-port connection circuit, it is unnecessary to conduct frequency gating by adding switches or combiners (duplexers), and two switches are directly head-jointed to each other through direct connection of different branch transmission lines and common transmission lines. The signal of the first frequency band is gated by controlling port impedance. The multi-port connection circuit avoids introduction of excessive elements, simplifies not only a circuit structure but also complexity of signal path switching, and reduces cost. In addition, an increase in insertion loss caused by introduction of excessive elements is avoided, and loss on a signal path is reduced. When the multi-port connection circuit is applied to the radio frequency front-end module, introduction of switches may be reduced, a method for directly head-jointing a transmission line is used, and complexity of antenna switching is further simplified. Thus, specifications of a TAS service and a CA service are improved, and transmission performance in a form of crossing the TAS service and the CA service is enhanced.

In a possible implementation, when the second end of the first switch is disconnected and the first end of the second switch and the second end of the second switch are connected, the first end of the first switch is in a high-impedance state in a second frequency band, and the first end of the second switch and the second end of the first common transmission line are in an impedance matching state in the second frequency band.

When the second end of the first switch is disconnected and the first end of the second switch and the second end of the second switch are connected, the first end of the first switch is in a high-impedance state in a second frequency band, and the first end of the second switch and the second end of the first common transmission line are in an impedance matching state in the second frequency band, such that a signal of the second frequency band may be transmitted with low loss. In a case without influencing normal transmission of the signal of the second frequency band, the first end of the first switch is in a high-impedance state in the second frequency band. For the signal of the second frequency band, an open circuit characteristic is achieved, such that the signal of the second frequency band fails to pass, and frequency gating is implemented. Meanwhile, loss on a signal path is reduced.

In a possible implementation, the impedance matching state is a state in which a port has matched impedance of fifty ohm; and/or, the high-impedance state is a state in which a reflection coefficient of a port is larger than a preset threshold.

In a possible implementation, the first switch is a single-pole multi-throw switch, and the second end of the first switch and any one of the other ends of the first switch are two ends that are capable of being connected; and/or, the second switch is a single-pole multi-throw switch, and the second end of the second switch and any one of the other ends of the second switch are two ends that are capable of being connected.

Port forms of the first switch and the second switch may be flexibly selected as required, to satisfy requirements in different scenes.

In a possible implementation, the second frequency band is a frequency band of a signal passing the first common transmission line and the second branch transmission line, and a frequency of the second frequency band is higher than that of the first frequency band. When the second end of the first switch is disconnected and the first end of the second switch and the second end of the second switch are connected, a difference between a sum of an electrical length of the first branch transmission line, an electrical length of the second branch transmission line and an equivalent phase shift of the first switch and a first value is smaller than or equal to a first preset error threshold, and the first value is a sum of an integer multiple of a first carrier wave length corresponding to the second frequency band and a quarter of the first carrier wave length; or, a difference between two times of an electrical length of the first branch transmission line and a second value is smaller than or equal to a second preset error threshold, a difference between two times of a sum of an electrical length of the second branch transmission line and an equivalent phase shift of the first switch and the second value is smaller than or equal to the second preset error threshold, and the second value is an integer multiple of a first carrier wave length.

Optionally, the first preset error threshold and the second preset error threshold may be same or not.

The electrical length of the first branch transmission line is denoted by RouteA, and the electrical length of the second branch transmission line is denoted by RouteB. That is, in a case with the signal of the second frequency band having high frequency, if RouteA, RouteB, shifteroff and a carrier wave length $\lambda$ satisfy either of the following formula (6) or formula (8), it may be ensured that when a signal having high frequency is transmitted, insertion loss of the signal path is not additionally introduced due to a mismatch or only small insertion loss is introduced.

In a possible implementation, the first end of the first switch is further connected to a first end of a first phase shift network, and the first end of the second switch is further connected to a first end of a second phase shift network. When the first end of the first switch and the second end of the first switch are connected and the first end of the second switch and the second end of the second switch are connected, a second end of the first phase shift network and the second end of the first common transmission line are in an impedance matching state in the first frequency band, and the first phase shift network is used for suppressing a signal in the second frequency band. A second end of the second phase shift network and the second end of the first common transmission line are in an impedance matching state in the second frequency band, and the second phase shift network is used for suppressing a signal in the first frequency band.

In the implementation, channels having different frequencies may be gated without introducing a switch, low insertion loss of a signal path is ensured while a switching scene of switches is simplified, and a use scene is expanded, such that the use scene is richer.

In a possible implementation, the first switch is a multi-pole multi-throw switch, a third end of the first switch and the first end of the first switch are two ends that are capable of being connected, and the third end of the first switch and a fourth end of the first switch are two ends that are capable of being connected; and/or, the second switch is a multi-pole multi-throw switch, a third end of the second switch and the first end of the second switch are two ends that are capable of being connected, and the third end of the second switch and a fourth end of the second switch are two ends that are capable of being connected.

Port forms of the first switch and the second switch may be flexibly selected as required, to satisfy requirements in different scenes. When the first switch and the second switch include more ports, sharing with other signal channels may be implemented, thus expanding an application scene.

In a possible implementation, the multi-port connection circuit further includes: a third branch transmission line, a fourth branch transmission line, and a second common transmission line. The third end of the first switch is connected to a first end of the third branch transmission line, and the third end of the second switch is connected to a first end of the fourth branch transmission line. A second end of the third branch transmission line and a second end of the fourth branch transmission line are both directly connected to a first end of the second common transmission line.

In a possible implementation, when the third end of the first switch and the fourth end of the first switch are connected and the third end of the second switch is disconnected, the fourth end of the first switch and a second end of the second common transmission line are in an impedance matching state in a third frequency band, and the fourth end of the second switch is in a high-impedance state in a fourth frequency band. When the third end of the first switch is disconnected and the third end of the second switch and the fourth end of the second switch are connected, the fourth end of the first switch is in a high-impedance state in the fourth frequency band, and the fourth end of the second switch and the second end of the second common transmission line are in an impedance matching state in the fourth frequency band.

That is, the multi-port connection circuit may include two groups of head-joint transmission lines, and the circuit is further simplified, such that insertion loss of more signal paths is reduced. Complexity of signal path switching is further simplified, and cost is reduced. When the multi-port connection circuit is applied to the radio frequency front-end module, introduction of switches may be further reduced, and complexity of antenna switching is further simplified. Thus, specifications of a TAS service and a CA service are improved, and transmission performance in a form of crossing the TAS service and the CA service is enhanced.

In a possible implementation, a frequency of the fourth frequency band is higher than that of the third frequency band. When the first switch is disconnected and the third end of the second switch and the fourth end of the second switch are connected, a difference between a sum of an electrical length of the third branch transmission line, an electrical length of the fourth branch transmission line, and an equivalent phase shift of the first switch and a third value is smaller than or equal to a third preset error threshold, and the third value is a sum of an integer multiple of a second carrier wave length corresponding to the fourth frequency band and a quarter of the second carrier wave length; or, a difference between two times of an electrical length of the third branch transmission line and a fourth value is smaller than or equal to a fourth preset error threshold, a difference between two times of a sum of an electrical length of the fourth branch transmission line and an equivalent phase shift of the first switch and the fourth value is smaller than or equal to the fourth preset error threshold, and the fourth value is an integer multiple of a second carrier wave length.

Optionally, the third preset error threshold and the fourth preset error threshold may be same or not. The third preset error threshold and the fourth preset error threshold may be same as or different from the first preset error threshold and the second preset error threshold described above.

In the implementation, based on simplifying the circuit, it may further be ensured that when the signal having a high frequency is transmitted, insertion loss of the signal path is not additionally introduced due to a mismatch or only small insertion loss is introduced.

In a possible implementation, a first transmission path of the fifth frequency band includes: the first end of the first switch, the second end of the first switch, the first branch transmission line, and the first common transmission line. A second transmission path of the fifth frequency band includes: the first end of the first switch, the third end of the first switch, the third branch transmission line, and the second common transmission line.

In the implementation, the multi-port connection circuit can satisfy demands of a scene of dual-antenna switching in a transmission state, expands a use scene, and can improve a product specification.

In a possible implementation, a first reception path of the fifth frequency band includes: the first common transmission line, the second branch transmission line, the second end of the second switch, and the first end of the second switch. A second reception path of the fifth frequency band includes: the second common transmission line, the fourth branch transmission line, the third end of the second switch, and the fourth end of the second switch.

In the implementation, the multi-port connection circuit can satisfy demands of a scene of dual-antenna switching in a reception state, expands a use scene, and can improve a product specification.

In a possible implementation, the circuit further includes: a third switch, a fourth switch, a fifth branch transmission line, a sixth branch transmission line, a seventh branch transmission line, an eighth branch transmission line, a third common transmission line, and a fourth common transmission line. A first end of the third switch and a second end of the third switch are two ends that are capable of being connected. A first end of the fourth switch and a second end of the fourth switch are two ends that are capable of being connected. The second end of the third switch is connected to a first end of the fifth branch transmission line. The second end of the fourth switch is connected to a first end of the sixth branch transmission line. A second end of the fifth branch transmission line and a second end of the sixth branch transmission line are both directly connected to a first end of the third common transmission line. A third end of the third switch and a fourth end of the third switch are two ends that are capable of being connected. A third end of the fourth switch and a fourth end of the fourth switch are two ends that are capable of being connected. The third end of the third switch is connected to a first end of the seventh branch transmission line. The third end of the fourth switch is connected to a first end of the eighth branch transmission line. A second end of the seventh branch transmission line and a second end of the eighth branch transmission line are both directly connected to a first end of the fourth common transmission line.

In the implementation, the multi-port connection circuit may further include four groups of head-joint transmission lines, and the circuit is further simplified, such that insertion loss of more signal paths is reduced. Complexity of signal path switching is further simplified, and cost is reduced. When the multi-port connection circuit is applied to the radio frequency front-end module, introduction of switches may be further reduced, and complexity of antenna switching is further simplified. Thus, specifications of a TAS service and a CA service are improved, and transmission performance in a form of crossing the TAS service and the CA service is enhanced.

In a possible implementation, the first end of the first switch and a fifth end of the first switch are two ends that are capable of being connected. The fifth end of the first switch is connected to the first end of the third switch. A third transmission path of the fifth frequency band includes: the first end of the first switch, the fifth end of the first switch, the first end of the third switch, the second end of the third switch, the fifth branch transmission line, and the third common transmission line. A fourth transmission path of the fifth frequency band includes: the first end of the first switch, the fifth end of the first switch, the first end of the third switch, the third end of the third switch, the seventh branch transmission line, and the fourth common transmission line.

In the implementation, the multi-port connection circuit can satisfy demands of a scene of four-antenna switching in a transmission state, expands a use scene, and can improve a product specification.

In a possible implementation, a third reception path of the fifth frequency band includes: the third common transmission line, the sixth branch transmission line, the second end of the fourth switch, and the first end of the fourth switch. A fourth reception path of the fifth frequency band includes: the fourth common transmission line, the eighth branch transmission line, the third end of the fourth switch, and the fourth end of the fourth switch.

In the implementation, the multi-port connection circuit can satisfy demands of a scene of four-antenna switching in a reception state, expands a use scene, and can improve a product specification.

In a possible implementation, a third reception path of the fifth frequency band includes: the third common transmission line, the fifth branch transmission line, the second end of the third switch, and a fifth end of the third switch. A fourth reception path of the fifth frequency band includes: the fourth common transmission line, the seventh branch transmission line, the third end of the third switch, and the fourth end of the third switch.

In the implementation, the multi-port connection circuit can satisfy demands of a scene of four-antenna switching in a reception state, expands a use scene, and can improve a product specification.

A second aspect provides a radio frequency front-end module. The radio frequency front-end module includes one or more multi-port connection circuits according to any one of the technical solutions of the first aspect.

A third aspect provides an electronic device. The electronic device includes one or more multi-port connection circuits according to any one of the technical solutions of the first aspect.

A fourth aspect provides an electronic device. The electronic device includes one or more radio frequency front-end modules according to the technical solution of the second aspect.

Reference may be made to the above description about the multi-port connection circuit for an implementation principle and beneficial effects of the radio frequency front-end module and the electronic device, which will not be repeated herein.

**BRIEF** DESCRIPTION OF DRAWINGS

FIG. 1 shows a schematic structural diagram of an illustrative terminal device 100 according to an embodiment of the disclosure;
FIG. 2 shows a schematic structural diagram of a common circuit including a plurality of signal channels;
FIG. 3 shows a schematic structural diagram of an illustrative multi-port connection circuit according to an embodiment of the disclosure;
FIG. 4 shows a schematic structural diagram of another illustrative multi-port connection circuit according to an embodiment of the disclosure;
FIG. 5 shows a schematic diagram of a simplified model of a multi-port connection circuit according to an embodiment of the disclosure;
FIG. 6 shows a schematic diagram of a simplified model of a circuit in an ideal state according to an embodiment of the disclosure;
FIG. 7 shows an equivalent circuit diagram of an illustrative multi-port connection circuit according to an embodiment of the disclosure;

FIG. 8 shows an equivalent circuit diagram of an illustrative multi-port connection circuit according to an embodiment of the disclosure;

FIG. 9 shows a schematic structural diagram of yet another illustrative multi-port connection circuit according to an embodiment of the disclosure;

FIG. 10 shows a schematic structural diagram of yet another illustrative multi-port connection circuit according to an embodiment of the disclosure;

FIG. 11 shows a schematic structural diagram of yet another illustrative multi-port connection circuit according to an embodiment of the disclosure;

FIG. 12 shows a schematic structural diagram of yet another illustrative multi-port connection circuit according to an embodiment of the disclosure;

FIG. 13 shows a schematic structural diagram of yet another illustrative multi-port connection circuit according to an embodiment of the disclosure;

FIG. 14 shows a schematic structural diagram of yet another illustrative multi-port connection circuit according to an embodiment of the disclosure;

FIG. 15 shows a schematic diagram of a simplified circuit structure of the multi-port connection circuit shown in FIG. 14;

FIG. 16 shows a signal flow diagram of the circuit structure shown in FIG. 15;

FIG. 17 shows another signal flow diagram of the circuit structure shown in FIG. 15;

FIG. 18 shows yet another signal flow diagram of the circuit structure shown in FIG. 15;

FIG. 19 shows yet another signal flow diagram of the circuit structure shown in FIG. 15;

FIG. 20 shows yet another signal flow diagram of the circuit structure shown in FIG. 15;

FIG. 21 shows yet another signal flow diagram of the circuit structure shown in FIG. 15;

FIG. 22 shows yet another signal flow diagram of the circuit structure shown in FIG. 15;

FIG. 23 shows yet another signal flow diagram of the circuit structure shown in FIG. 15;

FIG. 24 shows yet another signal flow diagram of the circuit structure shown in FIG. 15;

FIG. 25 shows still another signal flow diagram of the circuit structure shown in FIG. 15;

FIG. 26 shows a schematic structural diagram of still another illustrative multi-port connection circuit according to an embodiment of the disclosure;

FIG. 27 shows an equivalent circuit diagram of an illustrative multi-port connection circuit according to an embodiment of the disclosure; and

FIG. 28 shows S parameter curve comparison diagrams of an illustrative multi-port connection circuit and a multi-port connection circuit in an ideal state according to an embodiment of the disclosure.

## DESCRIPTION OF EMBODIMENTS

Technical solutions in embodiments of the disclosure will be described below with reference to drawings in the embodiments of the disclosure. In the description of the embodiments of the disclosure, "/" means "or" unless otherwise specified. For example, A/B may represent A or B. "And/or" herein describes merely an association relationship between associated objects and represents that three relationships may exist. For example, A and/or B may represent the following three cases: only A exists, both A and B exist, and only B exists. In addition, in the description of the embodiments of the disclosure, "a plurality of" represents two or more.

The terms "first", "second" and "third" described below are merely intended for an objective of description, and should not be understood as indication or implication of relative importance or implicit indication of a quantity of indicated technical features. Thus, a feature limited by "first", "second", or "third" may explicitly or implicitly include one or more of the features.

A multi-port connection circuit and a radio frequency front-end module provided by the embodiments of the disclosure may be applied to a mobile phone, a tablet computer, a wearable device, an in-vehicle device, an augmented reality (AR)/virtual reality (VR) device, a notebook computer, an ultra-mobile personal computer (UMPC), a netbook, a personal digital assistant (PDA), and other terminal devices. A specific type of the terminal device is not limited by the embodiments of the disclosure.

With development of communications technologies, increasing requirements have been imposed on functions and performance of a terminal device, and higher specifications need to be supported by the terminal device. The terminal device needs to support more frequency bands and have more antennas to adapt to more communication scenes.

Generally, more radio frequency channels are added to a radio frequency front-end module of the terminal device, so as to expand a frequency band. For example, for a terminal device of a global specification, different zones need to support different frequency bands and frequency band combinations. Thus, more frequency bands need to be supported to cover a wider zone. Consequently, a number of radio frequency channels in the terminal device may increase, such that a larger number of switch ports are needed. For example, in a scene of non-standalone (NSA) of a 5th generation mobile communication technology (5G), or a scene of carrier aggregation (CA), simultaneous transmission of a plurality of radio frequency channels is needed. Such a requirement increases complexity of designing the radio frequency front-end module, and also increases complexity of switching of a radio frequency channel. Meanwhile, because of limited space of the terminal device, unlimited increase in the number of antennas to adapt to expansion of the radio frequency channels is impossible. Thus, a plurality of radio frequency channels generally share one antenna, so as to reduce the number of antennas. In this way, in a case with a limited number of antennas and a large number of radio frequency channels, a complex switching scene of each radio frequency channel in the radio frequency front-end module is caused. To address a complex scene of radio frequency channel switching, the number of switches may be increased, or switches having more ports may be used to satisfy demands of the complex switching scene. However, increase in the number of switches or use of the switches having more ports will lead to an increase in insertion loss of a single radio frequency channel, as well as an increase in power consumption of the terminal device.

An embodiment of the disclosure provides a multi-port connection circuit. The multi-port connection circuit may be applied to a radio frequency front-end module or a terminal device. By designing port impedance of each radio frequency channel of the multi-port connection circuit, each radio frequency channel presents an impedance matching state for a frequency of a signal that needs to directly pass, such that a signal can be transmitted with low loss. A high-impedance state is presented for a signal that does not need to pass, and an open circuit characteristic is achieved, such that signal passing is avoided. In this way, different radio frequency channels may gate signals having different frequencies without introducing switches, such that the circuit is simplified, an increase in insertion loss caused by introducing switches or combiners is avoided, loss of channels is reduced, and meanwhile, cost is reduced.

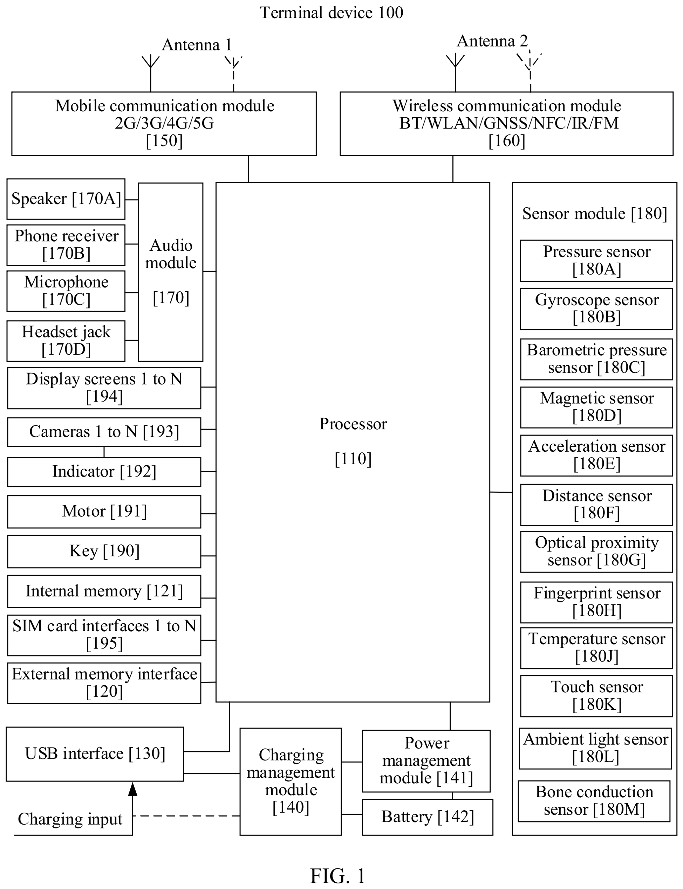

For example, FIG. 1 shows a schematic structural diagram of an illustrative terminal device 100 according to an embodiment of the disclosure. The terminal device 100 may include a processor 110, an external memory interface 120, an internal memory 121, a universal serial bus (USB) interface 130, a charging management module 140, a power management module 141, a battery 142, an antenna 1, an antenna 2, a mobile communication module 150, a wireless communication module 160, an audio module 170, a speaker 170A, a phone receiver 170B, a microphone 170C, a headset jack 170D, a sensor module 180, a key 190, a motor 191, an indicator 192, a camera 193, a display screen 194, a subscriber identification module (SIM) card interface 195, etc. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, etc.

It may be understood that the structure shown in the embodiment of the disclosure does not specifically limit the terminal device 100. In some other embodiments of the disclosure, the terminal device 100 may include more or fewer components than those shown in the figure, or may combine some components or split some components, or have a different component arrangement. The components shown in the figures may be implemented by hardware, software, or a combination of software and hardware.

The processor 110 may include one or more processing units. For example, the processor 110 may include an application processor (AP), a modem processor, a graphics processing unit (GPU), an image signal processor (ISP), a controller, a memory, a video codec, a digital signal processor (DSP), a baseband processor, and/or a neural-network processing unit (NPU), etc. Different processing units may be separate devices, or may be integrated into one or more processors.

The controller may be a nerve center and a command center of the terminal device 100. The controller may generate an operation control signal according to an instruction operation code and a sequence signal, and control obtaining and performing of instructions.

A wireless communication function of the terminal device 100 may be implemented with the antenna 1, the antenna 2, the mobile communication module 150, the wireless communication module 160, the modem processor, the baseband processor, etc.

The antenna 1 and the antenna 2 are configured to transmit and receive an electromagnetic wave signal. Structures of the antenna 1 and the antenna 2 in FIG. 1 are merely illustrative. Each antenna in the terminal device 100 may be configured to cover one or more communication frequency bands. Different antennas may be further multiplexed to increase a use ratio of the antennas. For example, the antenna 1 may be multiplexed as a diversity antenna in a wireless local area network. In some other embodiments, the antenna may be used with a tuning switch.

The mobile communication module 150 may provide a wireless communication solution that includes 2G/3G/4G/5G, etc. and that is applied to the terminal device 100. The mobile communication module 150 may include at least one filter, switch, power amplifier, low noise amplifier (LNA), etc. The mobile communication module 150 may receive an electromagnetic wave through the antenna 1, conduct processing such as filtering and amplification on the received electromagnetic wave, and transmit the processed electromagnetic wave to the modem processor for demodulation. The mobile communication module 150 may further amplify a signal obtained after modulation by the modem processor, and the amplified signal is converted into an electromagnetic wave through the antenna 1 for radiation. In some embodiments, at least some functional modules of the mobile communication module 150 may be arranged in the processor 110. In some embodiments, at least some functional modules of the mobile communication module 150 may be arranged in a same device as at least some modules of the processor 110.

The modem processor may include a modulator and a demodulator. The modulator is configured to modulate a to-be-transmitted low-frequency baseband signal into a middle or high-frequency signal. The demodulator is configured to demodulate the received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal through an audio device (not limited to the speaker 170A, the phone receiver 170B, etc.), or displays an image or a video through the display screen 194. In some embodiments, the modem processor may be a separate device. In some other embodiments, the modem processor may be independent of the processor 110 and may be arranged in a same device as the mobile communication module 150 or another functional module.

The wireless communication module 160 may provide a wireless communication solution that is applied to the terminal device 100 and that includes a wireless local area network (WLAN) (for example, a wireless fidelity (Wi-Fi) network), Bluetooth (BT), a global navigation satellite system (GNSS), frequency modulation (FM), a near field communication (NFC) technology, an infrared (IR) technology, etc. The wireless communication module 160 may be one or more devices into which at least one communication processing module is integrated. The wireless communication module 160 receives an electromagnetic wave through the antenna 2, conducts frequency modulation and filtering on an electromagnetic wave signal, and transmits the processed signal to the processor 110. The wireless communication module 160 may further receive a to-be-transmitted signal from the processor 110, conduct frequency modulation and amplification on the to-be-transmitted signal, and convert an amplified signal into an electromagnetic wave for radiation through the antenna 2.

In some embodiments, in the terminal device 100, the antenna 1 and the mobile communication module 150 are coupled to each other, and the antenna 2 and the wireless communication module 160 are coupled to each other, such that the terminal device 100 may be in communication with a network and another device through a wireless communication technology. The wireless communication technology may include a global system for mobile communications (GSM), a general packet radio service (GPRS), code division multiple access (CDMA), wideband code division multiple access (WCDMA), time-division code division multiple access (TD-CDMA), long term evolution (LTE), BT, a GNSS, a WLAN, NFC, FM, and/or an IR technology, etc. The GNSS may include a global positioning system (GPS), a global navigation satellite system (GLONASS), a Beidou navigation satellite system (BDS), a quasi-zenith satellite system (QZSS), and/or a satellite based augmentation system (SBAS).

In the terminal device shown in FIG. 1, the mobile communication module 150 and/or the wireless communication module 160 may be shown as including a radio frequency front-end module. For convenience of understanding, in the following embodiments of the disclosure, with a terminal device having the structure shown in FIG. 1 as an example, a multi-port connection circuit provided by the embodiments of the disclosure is specifically described with reference to the accompanying drawings and an application scene. It should be noted that in the radio frequency front-end module, in a scene of switching a radio frequency channel (a signal path) through a switch, the multi-port connection circuit shown in the embodiment of the disclosure may be used to simplify the circuit structure. Clearly, the multi-port connection circuit provided by the embodiment of the disclosure is not limited to be used in the radio frequency front-end module, and may be used in another scene of a gating signal. The scene is not limited by the embodiment of the disclosure. Then, a scene in which the multi-port connection circuit is used in the radio frequency front-end module is illustratively described.

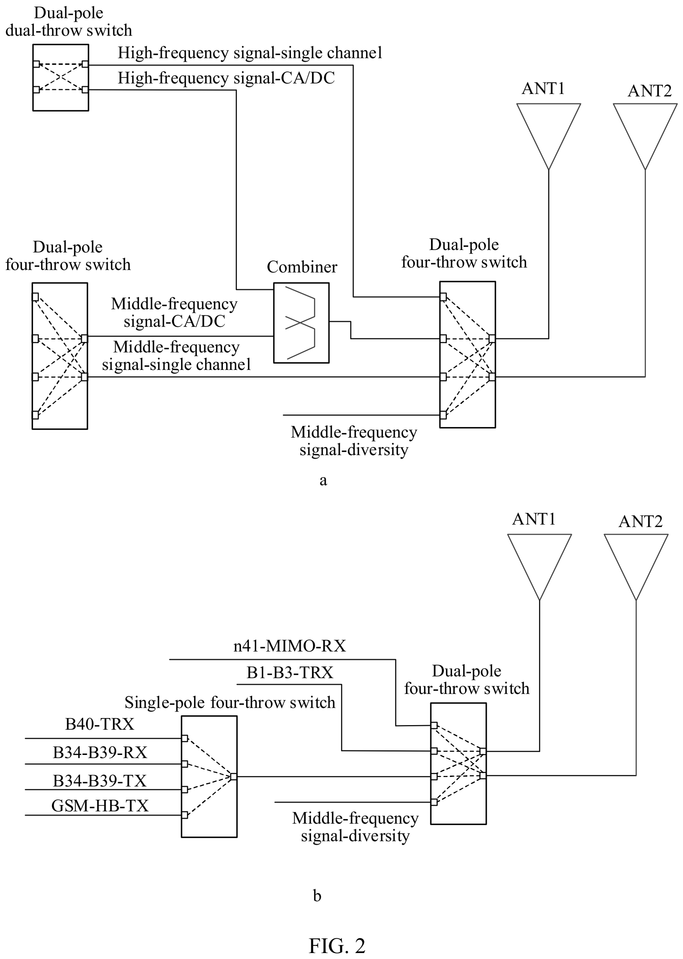

FIG. a of FIG. 2 shows a schematic diagram of some radio frequency channels in which a plurality of switches are cascaded in a common illustrative radio frequency front-end module. As shown in FIG. a of FIG. 2, a high-frequency signal of a single channel and a middle-frequency signal of a single channel both need to reach an antenna 1 (ANT1) or an antenna 2 (ANT2) from a dual-pole dual-throw switch or a dual-pole four-throw switch via two stages of switches. If a high-frequency signal or a middle-frequency signal in a carrier aggregation (CA) state or a dual-connectivity (DC) state needs to reach the antenna 1 (ANT1) or the antenna 2 (ANT2) via two stages of switches and a combiner (or referred to as a duplexer). FIG. b of FIG. 2 shows a schematic diagram of some radio frequency channels in which a plurality of switches are cascaded in another common illustrative radio frequency front-end module. As shown in FIG. b of FIG. 2, signals of B34, B39 and B40 and a GMS high-frequency transmission signal (GSM_HB_TX) need to reach an antenna 1 (ANT1) or an antenna 2 (ANT2) via two stages of switches.

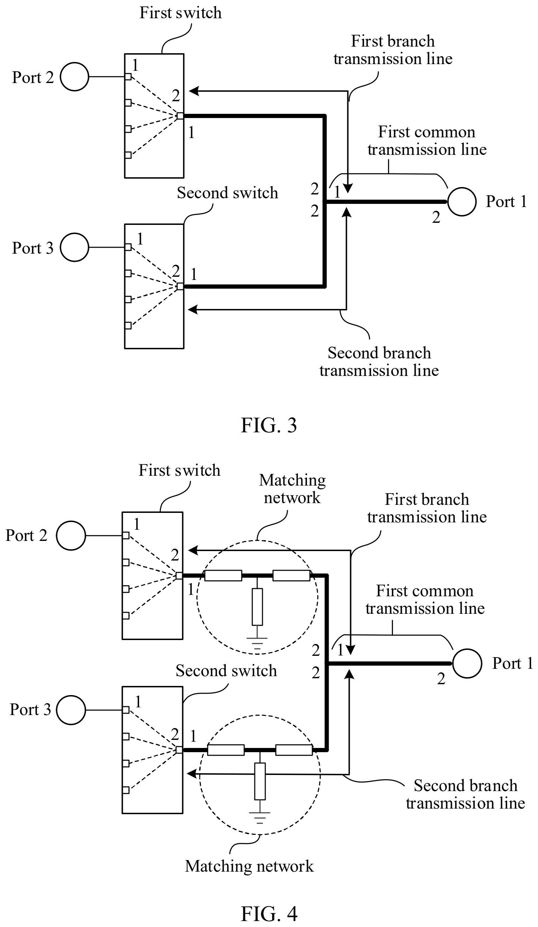

For a scene in which a radio frequency channel needs to be switched shown in FIG. 2, an embodiment of the disclosure provides a multi-port connection circuit. Reference may be made to FIG. 4 for details. The multi-port connection circuit includes: a first switch, a second switch, a first branch transmission line, a second branch transmission line, and a first common transmission line. A first end of the first switch and a second end of the first switch are two ends that are capable of being connected. A first end of the second switch and a second end of the second switch are two ends that are capable of being connected. That is, the first end of the first switch and the second end of the first switch are capable of being connected or disconnected under an effect of a control signal, and the first end of the second switch and the second end of the second switch are capable of being connected or disconnected under an effect of a control signal.

Optionally, the first switch may be a single-pole dual-throw switch, the second end of the first switch may be a common end of the switch, and the first end of the first switch may be either of two discrete ends. Optionally, the first switch may be a single-pole three-throw switch, a single-pole four-throw switch, or another single-pole multi-throw switch. If the second end of the first switch may be a common end of the first switch, the first end of the first switch may be any one of a plurality of discrete ends. FIG. 3 uses a case that the first switch is a single-pole four-throw switch and the first end of the first switch is a discrete end 1 as an example. Optionally, the first switch may be a multi-pole multi-throw switch, for example, a dual-pole three-throw switch, a dual-pole dual-throw switch, a dual-pole four-throw switch, a dual-pole five-throw switch, a three-pole three-throw switch, a three-pole four-throw switch, etc., and is not limited by the embodiment of the disclosure.

Optionally, the second switch may be a single-pole dual-throw switch, the second end of the second switch may be a common end of the second switch, and the first end of the second switch may be either of two discrete ends. Optionally, the second switch may be a single-pole three-throw switch, a single-pole four-throw switch, or another single-pole multi-throw switch. The second end of the second switch may be a common end of the second switch, the first end of the second switch may be any one of a plurality of discrete ends. FIG. 3 uses a case that the second switch is a single-pole four-throw switch and the first end of the second switch is a discrete end 1 as an example. Optionally, the second switch may be a multi-pole multi-throw switch, for example, a dual-pole three-throw switch, a dual-pole dual-throw switch, a dual-pole four-throw switch, a dual-pole five-throw switch, a three-pole three-throw switch, a three-pole four-throw switch, etc., and is not limited by the embodiment of the disclosure.

The first switch and the second switch may be same or not, and are not limited by the embodiment of the disclosure, as long as the first switch includes the first end and the second end that are capable of being connected and disconnected and the second switch includes the first end and the second end that are capable of being connected and disconnected.

Specifically, the second end of the first switch is connected to a first end of the first branch transmission line, the second end of the second switch is connected to a first end of the second branch transmission line, and a second end of the first transmission line and a second end of the second branch transmission line are both directly connected to a first end of the first common transmission line. The first ends in FIG. 3 are labeled with number "1", and the second ends are labeled with number "2".

For the entire multi-port connection circuit shown in FIG. 3, external ports include: a port 1, a port 2, and a port 3. When the first switch is connected, the first end of the first switch and the second end of the first switch are connected and the second end of the second switch is disconnected, the first end of the first switch and a second end of the first common transmission line are in an impedance matching state in a first frequency band, and the first end of the second switch is in a high-impedance state in the first frequency band.

It should be noted that in the embodiment of the disclosure, a case that an end of a switch is disconnected indicates that a disconnected port and any other port of the switch are not connected. For example, the port may be suspended. Specifically, a case that an end of a switch is disconnected may indicate that the port and other ports of the switch are not connected, and the other ports may be connected; or, may indicate that all ports of the switch are not connected, that is, the entire switch is disconnected (or in an off state). In addition, it is expected that impedance of the port disconnected is close to an infinitely high-impedance state.

That is, when a signal of the first frequency band flows into the multi-port connection circuit from the port 1, the first end of the first switch and the second end of the first common transmission line are in the impedance matching state in the first frequency band, such that the signal of the first frequency band may be transmitted to the port 2 with relatively low insertion loss. In other words, a large transmission coefficient (S12) between the port 1 and the port 2 presents a direct-through transmission characteristic with low loss. In addition, for the first frequency band, the first end of the second switch is in a high-impedance state, equivalent to an open circuit state, in the first frequency band. In this way, the signal that flows into the first frequency band from the port 1 fails to reach the port 3 through the second switch.

When a signal of the first frequency band flows into the multi-port connection circuit from the port 2, the first end of the first switch and the second end of the first common transmission line are in the impedance matching state in the first frequency band, such that the signal of the first frequency band may be transmitted to the port 1 with relatively low insertion loss. In other words, a large transmission coefficient (S21) between the port 2 and the port 1 presents a direct-through transmission characteristic with low loss. In addition, for the first frequency band, the first end of the second switch is in a high-impedance state, equivalent to an open circuit state, in the first frequency band. In this way, the signal that flows into the first frequency band from the port 2 fails to reach the port 3 through the second switch.

Optionally, the impedance matching state may be a state in which a port has impedance of 50 ohm or close to 50 ohm, and for example, 49 ohm, 48 ohm, 45 ohm, 51 ohm, 52 ohm, or 55 ohm. As long as a difference from 0 ohm is small, such as smaller than 5 ohm, 3 ohm or other small impedance differences, loss of transmission energy may be within an acceptable range. In this way, the port is in the impedance matching state.

Optionally, the impedance matching state may be implemented by adjusting port impedance through adjustment of a line width and a material of the first common transmission line and/or the first branch transmission line, or by adjusting port impedance by additionally arranging a matching network on the first common transmission line and/or the first branch transmission line and debugging an electrical performance parameter of the matching network. Optionally, the matching network may be a T-type, L-type or II-type network composed of elements having lumped parameters, and a specific value of capacitance or inductance at each matching bit in the matching network is not limited. Optionally, the matching network may be a network composed of elements having distributed parameters, such as copper foils having different sizes or shapes.

Optionally, the high-impedance state may be achieved by adjusting impedance through adjustment of a line width and a material of the first common transmission line and/or the second branch transmission line, or by adjusting impedance by additionally arranging a matching network on the first common transmission line and/or the second branch transmission line and debugging an electrical performance parameter of the matching network. Reference may be made to related description in the impedance matching state for an implementation form of the matching network.

Optionally, the high-impedance state may be a state in which port impedance is large in value. For example, the port impedance is 1000 ohm, or is smaller than and close to 1000 ohm, or is larger than 1000 ohm, and for example, 900 ohm, 950 ohm, 1050 ohm, 1100 ohm or above. Generally, in a high-impedance state, a reflection state of the port is expected to be total reflection. With the port 3 as an example, a reflection coefficient S33 is aimed at being close to 0, and a larger reflection coefficient is better, and for example, is larger than -0.5 dB.

It may be seen that both the impedance matching state and the high-impedance state may be implemented by debugging a matching network on a signal path. FIG. 4 shows an example of a matching network in a form of a T-type network composed of elements having lumped parameters. In FIG. 4, each matching bit in the matching network may be a capacitor or an inductor. Specifically, a capacitance value and an induction value are subject to reaching a required impedance matching state.

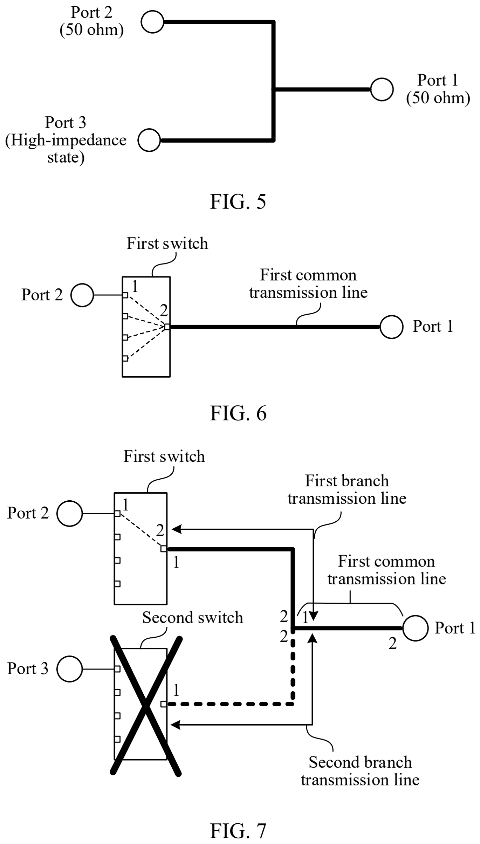

To clearly describe a case of port impedance when the first end of the first switch and the second end of the first switch are connected and the second end of the second switch is disconnected, the circuit shown in FIG. 3 or FIG. 4 may be simplified to a model shown in FIG. 5. In FIG. 5, port impedance of a port 1 and a port 2 is 50 ohm or close to 50 ohm, and port impedance of a port 3 is in a high-impedance state, and for example, 1000 ohm.

In the multi-port connection circuit shown in FIG. 3, the second end of the first transmission line and the second end of the second branch transmission line are both directly connected to the first end of the first common transmission line. When the first end of the first switch and the second end of the first switch are connected and the second end of the second switch is disconnected, the first end of the first switch and a second end of the first common transmission line are in an impedance matching state in a first frequency band, such that a signal of the first frequency band may be transmitted with low loss. In a case without influencing normal transmission of the signal of the first frequency band, the first end of the second switch is in a high-impedance state in the first frequency band. For the signal of the first frequency band, an open circuit characteristic is achieved, such that the signal of the first frequency band fails to pass, and frequency gating is implemented. In the multi-port connection circuit shown in FIG. 3, it is unnecessary to conduct frequency gating by adding switches or combiners (duplexers), and two switches are directly head-jointed to each other through direct connection of different branch transmission lines and common transmission lines. The signal of the first frequency band is gated by controlling port impedance. The multi-port connection circuit avoids introduction of excessive elements, simplifies not only a circuit structure but also complexity of signal path switching, and reduces cost. In addition, an increase in insertion loss caused by introduction of excessive elements is avoided, and loss on a signal path is reduced. When the multi-port connection circuit is applied to the radio frequency front-end module, introduction of switches may be reduced, a method for directly head-jointing a transmission line is used, and complexity of antenna switching is further simplified. Thus, specifications of a TAS service and a CA service are improved, and transmission performance in a form of crossing the TAS service and the CA service is enhanced.

Optionally, in the multi-port circuit shown in FIG. 3, a signal of the second frequency band may further be gated through channels of the port 1 and the port 3. When the second end of the first switch is disconnected and the first end of the second switch and the second end of the second switch are connected, the first end of the first switch is in a high-impedance state in a second frequency band, and the first end of the second switch and the second end of the first common transmission line are in an impedance matching state in the second frequency band, such that a signal of the second frequency band may be transmitted with low loss. In a case without influencing normal transmission of the signal of the second frequency band, the first end of the first switch is in a high-impedance state in the second frequency band. For the signal of the second frequency band, an open circuit characteristic is achieved, such that the signal of the second frequency band fails to pass, and frequency gating is implemented. Meanwhile, loss on a signal path is reduced.

The first branch transmission line, the second branch transmission line and the first common transmission line may be regarded as a group of head-joint transmission lines. Without introduction of elements such as switches and combiners, frequency gating can be implemented, and a low insertion loss characteristic of a signal path can be ensured.

To clearly describe an implementation principle of the embodiment shown in FIG. 3, factors influencing insertion loss on the signal path are described herein. With the multi-port connection circuit shown in FIG. 3 as an example, insertion loss composition of the port 2 to the port 1 in the first frequency band may include the following:

1, insertion loss of the first common transmission line, which is denoted by ILcommon;

2, insertion loss of the first branch transmission line, which is denoted by ILA;

3, device insertion loss of the first switch in an on state, which is denoted by IL1;

4, return loss introduced by the second branch transmission line and insertion loss introduced by the impedance matching state, which are denoted by ILB; and

5, return loss introduced because impedance of a port disconnected of the second switch cannot reach an infinitely high-impedance state and insertion loss introduced by the impedance matching state, which are denoted by ILoff.

Thus, in a process in which the signal of the first frequency band flows from the port 2 to the port 1, insertion loss ILtotle of an entire signal path is:

$$\text{ILtotle} = \text{ILcommon} + \text{ILA} + \text{IL1} + \text{ILB} + \text{ILoff} \qquad \text{Formula (1)}$$

When the first common transmission line and elements in the multi-port connection circuit are fixed, ideal insertion loss ILideal from the port 2 to the port 1 is:

$$\text{ILideal} = \text{ILcommon} + \text{IL1} \qquad \text{Formula (2)}$$

Reference may be made to FIG. 6 for an equivalent circuit diagram of the multi-port connection circuit in a case of ideal insertion loss. Insertion loss of a signal path from the port 2 to the port 1 in the first frequency band is ILcommon + IL1. ILcommon and IL1 are fixed insertion loss and cannot be avoided.

Then, the formula (1) is subtracted from the formula (2), such that additionally introduced insertion loss ILtotle-ILideal is obtained, and may be expressed as the following relational formula:

$$\text{ILtotle} - \text{ILideal} = \text{ILA} + \text{ILB} + \text{ILoff} \qquad \text{Formula (3)}$$

Three terms, that is, ILA, ILB, and ILoff, at a right side of the formula (3) are adjustable indicators that influence insertion loss.

It may be understood that a carrier wave length is a ratio of a light velocity to a frequency, that is, a relational formula $v = \lambda \times f$ is satisfied. The light velocity v in air may be approximated as a value $3 \times 10^8$ m/s of the light velocity in vacuum. Thus, for a range of 450 MHz to 7200 MHz of a communication frequency f used for mobile communication, a corresponding carrier wave length $\lambda$ is in a range of 0.04 m (corresponding to 7200 MHz) $\leq \lambda \leq$ 0.67 m (corresponding to 450 MHz).

For a common low communication frequency, a carrier wave length is longer. For example, a frequency of 2000 MHz corresponds to a carrier wave length of 0.15 m, that is, 15 cm. A length of a transmission line on a signal path is generally as short as possible, and for example, may be 5 mm. In this case, the length of the transmission line is far smaller than a carrier wave length compared with the carrier wave length, that is, the length of the transmission line is incomparable to the carrier wave length. In this case, after a signal passes the transmission line, a phase change is very small, influence caused by the phase change may be ignored, and a signal transmission requirement may be satisfied with attention paid only to port impedance. That is, for a relatively low communication frequency, only factors that influence impedance matching need to be considered, such as a material, a line width, and a matching network.

However, for a relatively high communication frequency, a carrier wave length is shorter. For example, a carrier wave length corresponding to 7200 MHz is 0.04 m, that is, 4 cm. Thus, a length of a transmission line on a signal path is approximately 5 mm and is comparable to the carrier wave length of 4 cm. That is, when the length of the transmission line is close to the carrier wave length, attention needs to be paid to a phase change during signal transmission.

Specifically, with a high-frequency signal having a high transmission frequency as an example, the electrical length of the first branch transmission line is denoted by RouteA, and the electrical length of the second branch transmission line is denoted by RouteB, such that RouteA, RouteB, and the carrier wave length $\lambda$ need to satisfy either of the following formula (4) or formula (5) to ensure low insertion loss:

$$\text{RouteA} + \text{RouteB} = \alpha\lambda + k\lambda/4, \qquad \text{Formula (4)}$$

$$2 \times \text{RouteA} = 2 \times \text{RouteB} = \alpha\lambda + k\lambda \qquad \text{Formula (5)}$$

$\alpha$ is an integer, and a value of $\alpha$ in the formula (4) and the formula (5) may be same or not. Optionally, an ideal value of k is 1. However, in an actual circuit, a value of k may be close to 1 between 0.5 to 1.5, and for example, 1.01, 1.1, 0.9, 0.8, etc., and values of k in the formula (4) and the formula (5) may be different. When a value of k is close to 1, the formula (4) and the formula (5) are approximately workable. That is, when a value of k is 1, equal signs in the formula (4) and the formula (5) may be approximately equal signs ($\approx$). No matter a value of k is close to 1, or k is equal to 1 and an equal sign is changed to an approximately equal sign, RouteA, RouteB, and the carrier wave length may satisfy the formula (4) or the formula (5).

With the circuit structure shown in FIG. 3 as an example, if RouteA, RouteB and the carrier wave length $\lambda$ satisfy the formula (4), for the port 2 and the port 3, a difference between a transmitted signal phase (also referred to as a carrier phase) and a reflected signal phase is 90 degrees or close to 90 degrees, such that an increase in insertion loss caused by impedance mismatching may be reduced. Thus, an open circuit state is achieved from the port 2 to the port 3, and an open circuit state is achieved from the port 3 to the port 2. That is, for one port, another branch transmission line and switch have no influence on insertion loss of a signal path corresponding to the port. With the port 2 as an example, if RouteA, RouteB and the carrier wave length $\lambda$ satisfy the formula (4), additional insertion loss ILB and ILoff that appear in the signal path between the port 1 to the port 2 due to existence of the second branch transmission line and the second switch may be avoided or reduced. Thus, it may be ensured that the insertion loss of the signal path is lower.

If RouteA, RouteB, and the carrier wave length $\lambda$ satisfy the formula (5), when a signal is transmitted from the port 2 to the port 3 and then is returned from the port 3 to the port 2, a phase undergoes a change of approximately an integer multiple of a half-wave length and is same as a phase originally at the port 2. This case indicates that the phase does not change. That is, if a phase of a signal reflected from the port 3 is same as a phase on an original signal path (also referred to as a carrier phase), no loss is caused to the signal. With a case that the signal path is a path from the port 1 to the port 2 as an example, the case is equivalent to a case that additional insertion loss ILB and ILoff is not introduced or is reduced. Thus, it may be ensured that insertion loss of the signal path is lower.

That is, if RouteA, RouteB and the carrier wave length $\lambda$ satisfy either of the following formula (4) or formula (5), it may be ensured that when a high-frequency signal is transmitted, insertion loss of the signal path is not additionally introduced due to a mismatch or only small insertion loss is introduced. Clearly, if RouteA, RouteB and the carrier wave length $\lambda$ do not satisfy either of the following formula (4) or formula (5), it indicates that when a high-frequency signal is transmitted, insertion loss of the signal path may be obviously additionally introduced due to a mismatch, causing high insertion loss of the signal path and influencing transmission performance.

However, generally, when a switch is disconnected, the switch is not in a physically disconnected state in the strict sense, that is, cannot reach an infinitely high-impedance state. Thus, the switch disconnected or a port of the switch still causes return loss to a transmitted signal, influencing insertion loss on a signal path, that is, ILoff appears. However, a value of ILoff depends on a characteristic of the switch itself. If return loss of the port of the switch is very large, that is, a reflection coefficient is relatively small, and for example, smaller than -0.5 dB, large ILoff exists even if the switch is disconnected. In this case, a phase of a signal may be changed by adding a phase shift network to the path, to offset a phase change caused by return loss. In this case, a phase change brought by the return loss may be considered as an equivalent phase shift of the switch, and is denoted by shifteroff. Thus, RouteA, RouteB, shifteroff and the carrier wave length $\lambda$ need to satisfy either of the following formula (6) or formula (7) to ensure low insertion loss:

$$\mathrm{RouteA+RouteB+shifteroff}=\alpha\lambda+k\lambda/4, \qquad \text{Formula (6)}$$

$$2\times\mathrm{RouteA}=2\times(\mathrm{RouteB+shifteroff})=\alpha\lambda+k\lambda \qquad \text{Formula (7)}$$

In the formula, $\alpha$ is an integer, and a value of $\alpha$ in the formula (6) and the formula (7) may be same or not. Optionally, an ideal value of k is 1. However, in an actual circuit, a value of k may be close to 1 between 0.5 to 1.5, and for example, 1.01, 1.1, 0.9, 0.8, etc., and values of k in the formula (6) and the formula (7) may be different. When a value of k is close to 1, the formula (4) and the formula (5) are approximately workable. That is, when a value of k is 1, equal signs in the formula (6) and the formula (7) may be approximately equal signs ($\approx$). No matter a value of k is close to 1, or k is equal to 1 and an equal sign is changed to an approximately equal sign, RouteA, RouteB, shifteroff and the carrier wave length may satisfy the formula (6) or the formula (7).

With the circuit structure shown in FIG. 3 as an example, if RouteA, RouteB, shifteroff and the carrier wave length $\lambda$ satisfy the formula (6), for the port 2 and the port 3, a difference between a transmitted signal phase (also referred to as a carrier phase) and a reflected signal phase is 90 degrees or close to 90 degrees, such that an increase in insertion loss caused by impedance mismatching may be reduced. Thus, an open circuit state is achieved from the port 2 to the port 3, and an open circuit state is achieved from the port 3 to the port 2. That is, for one port, another branch transmission line and switch have no influence on insertion loss of a signal path corresponding to the port. With the port 2 as an example, additional insertion loss ILB and ILoff that appear in the signal path between the port 1 to the port 2 due to introduction of the second branch transmission line and the second switch may be avoided or reduced. Thus, it may be ensured that the insertion loss of the signal path is lower.

If RouteA, RouteB, and the carrier wave length λ satisfy the formula (7), when a signal is transmitted from the port 2 to the port 3 and then is returned from the port 3 to the port 2, a phase undergoes a change of approximately an integer multiple of a half-wave length and is same as a phase originally at the port 2. This indicates that the phase does not change. That is, if a phase of a signal reflected from the port 3 is same as a phase on an original signal path (also referred to as a carrier phase), no loss is caused to the signal. With a case that the signal path is a path from the port 1 to the port 2 as an example, if RouteA, RouteB, shifteroff and the carrier wave length λ satisfy the formula (6), the case is equivalent to a case that additional insertion loss ILB and ILoff is not introduced or is reduced. Thus, it may be ensured that insertion loss of the signal path is lower.

That is, if RouteA, RouteB and the carrier wave length λ satisfy either of the following formula (6) or formula (7), it may be ensured that when a high-frequency signal is transmitted, insertion loss of the signal path is not additionally introduced due to a mismatch or only small insertion loss is introduced. Clearly, if RouteA, RouteB, shifteroff and the carrier wave length λ do not satisfy either of the following formula (6) or formula (7), it indicates that when a high-frequency signal is transmitted, insertion loss of the signal path may be obviously additionally introduced due to a mismatch, and for example, ILB and ILoff are large, causing high insertion loss of the signal path and influencing transmission performance.

Based on characteristic description of high-frequency signal transmission, an embodiment of the disclosure further provides a multi-port connection circuit. Reference may be made to FIG. 3 or FIG. 4 for a specific structure. A first frequency band has a relatively low frequency, and a length of a transmission line is far smaller than a carrier wave length of the first frequency band, and is incomparable to the carrier wave length of the first frequency band. A second frequency band has a relatively high frequency, and the length of the transmission line is close to a carrier wave length corresponding to the second frequency band, and is comparable to the carrier wave length.

When a first end of a first switch and a second end of the first switch are connected and a second end of a second switch is disconnected, if a signal of the first frequency band passes, the first end of the first switch and a second end of a first common transmission line are in an impedance matching state in the first frequency band, and a first end of the second switch is in a high-impedance state in the first frequency band. In this case, the signal of the first frequency band may pass a signal path from a port 1 to a port 2 with low loss.

When the second end of the first switch is disconnected and the first end of the second switch and the second end of the second switch are connected, a difference between a sum of an electrical length of a first branch transmission line, an electrical length of a second branch transmission line and an equivalent phase shift of the first switch and a first value may be smaller than or equal to a first preset error threshold. The first value is a sum of an integer multiple (αλ) of a first carrier wave length corresponding to a quarter of the second frequency band and a quarter of the first carrier wave length (kλ/4). Herein, k is 1. That is, the electrical length of the first branch transmission line, the electrical length of the second branch transmission line, and the equivalent phase shift of the first switch satisfy a relationship of the formula (6). In this case, if a switch having a port disconnected is the first switch and a signal path is from the port 1 to a port 3, shifteroff in the formula (6) denotes an equivalent phase shift corresponding to a case that the second end of the first switch is disconnected. In this way, for the signal path between the port 1 and the port 3, additional insertion loss ILA and ILoff caused by introduction of the first branch transmission line and the first switch may be avoided or reduced, such that low insertion loss of the signal path between the port 1 and the port 3 can be ensured.

Optionally, when the second end of the first switch is disconnected and the first end of the second switch and the second end of the second switch are connected, a difference between two times of the electrical length of the first branch transmission line and a second value is smaller than or equal to a second preset error threshold, and a difference between two times of a sum of the electrical length of the second branch transmission line and an equivalent phase shift of the first switch in the second frequency band and a second value may be smaller than or equal to a second preset error threshold. The second value is an integer multiple of the first carrier wave length corresponding to the second frequency band. That is, the electrical length of the first branch transmission line, the electrical length of the second branch transmission line, and the equivalent phase shift of the first switch satisfy an evolved relational formula of the formula (7). The first preset error threshold and the second preset error threshold may be same or not. Both the first preset error threshold and the second preset error threshold may be small, and for example, may be ±0.5, ±0.1, ±0.01, ±0.05, etc. Specific values of the first preset error threshold and the second preset error threshold are not limited by the embodiment of the disclosure. In this case, if a switch having a port disconnected is the first switch and a signal path is from the port 1 to the port 3, shifteroff in the formula (7) denotes an equivalent phase shift corresponding to a case that the second end of the first switch is disconnected, and the formula (7) is adaptively evolved into the formula (8):

$$2\times\text{RouteB}=2\times(\text{RouteA}+\text{shifteroff})=\alpha\lambda+k\lambda \qquad \text{Formula (8)}$$

In the formula, α is an integer. Optionally, an ideal value of k is 1. However, in an actual circuit, a value of k may be close to 1 between 0.5 to 1.5, and for example, 1.01, 1.1, 0.9, 0.8, etc. When a value of k is close to 1, the formula (85) is approximately workable. That is, when a value of k is 1, an equal sign in the formula (8) may be an approximately equal sign (≈). No matter a value of k is close to 1, or k is equal to 1 and an equal sign is changed to an approximately equal sign, RouteA, RouteB, shifteroff and the carrier wave length may satisfy the formula (8).

In addition, in the formula (5), formula (7), and formula (8), if a value of $\alpha$ is close to an integer, and for example, values close to an integer 5 such as 5.1 and 4.9, or values close to an integer 4 such as 3.95 and 4.02, k may be 0, and a right side of the formula (5), the formula (7) and the formula (8) may be simplified as $\alpha\lambda$.

Based on a same principle as the formula (7), for the signal path between the port 1 and the port 3, additional insertion loss ILA and ILoff caused by introduction of the first branch transmission line and the first switch may be avoided or reduced, such that low insertion loss of the signal path between the port 1 and the port 3 can be ensured.

It should be noted that in the embodiment of the disclosure, it is said that some parameters satisfy a certain formula and are required to satisfy a relationship of the formula. That is, a relationship between the parameters makes an equation of the formula workable or a variable form of the formula workable. Alternatively, an equal sign in the formula may be changed to an approximately equal sign (≈). That is, values at two sides of the formula are made to be close to each other, and are not necessarily completely equal to each other. For example, a difference between the values at the two sides of the formula is made smaller than or equal to a preset error threshold. The preset error threshold is a small value, and for example, a value such as ±0.5, ±0.1, ±0.01, or ±0.05. A specific value of the preset error threshold is not limited by the embodiment of the disclosure.

It should be noted that a carrier wave length corresponding to the frequency band described above may be a carrier wave length corresponding to a central frequency of the frequency band, or a carrier wave length corresponding to a frequency point within the frequency band. When an input signal has a fixed frequency, the carrier wave length is a wave length corresponding to the fixed frequency. If the input signal is a signal whose frequency point changes within a frequency range, the carrier wave length may be a wave length corresponding to a central frequency of a frequency band range, and be compatible with a characteristic of an entire frequency band as much as possible.

No matter whether a size of the transmission line in the multi-port connection circuit is comparable to the carrier wave length corresponding to the second frequency band, that is, the frequency of the signal of the first frequency band is lower, when the signal of the first frequency band needs to be gated, the first end of the first switch and the second end of the first switch are connected, and the second end of the second switch is disconnected. In this case, the port 1 and the port 2 are in an impedance matching state, and the signal path between the port 1 and the port 2 may transmit the signal of the first frequency band with low insertion loss. Thus, a schematic structural diagram of a multi-port connection circuit shown in FIG. 3 may be equivalent to an equivalent circuit diagram shown in FIG. 7. A path (including the second switch and the second branch transmission line) corresponding to the second switch in FIG. 7 is equivalent to nonexistence.

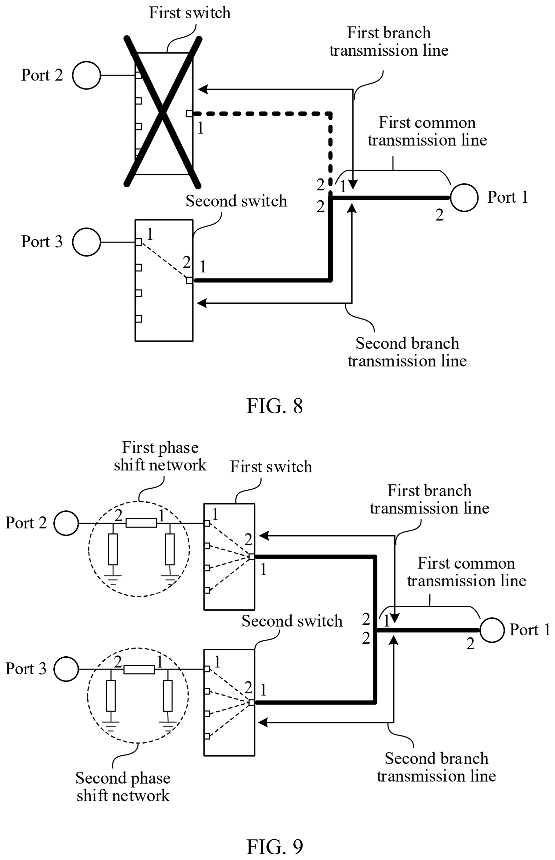

When the signal of the second frequency band needs to be gated, the first end of the second switch and the second end of the second switch are connected, and the first end of the first switch is disconnected. In this case, if the size of the transmission line in the multi-port connection circuit is incomparable to the carrier wave length corresponding to the second frequency band, that is, the frequency of the signal of the second frequency band is lower, the port 1 and the port 3 are in an impedance matching state, and the signal path between the port 1 and the port 3 may transmit the signal of the second frequency band with low insertion loss. If the size of the transmission line of the multi-port connection circuit is comparable to the carrier wave length corresponding to the second frequency band, the size of the transmission line satisfies the formula (6) or the formula (8), such that the signal of the second frequency band is transmitted on the signal path between the port 1 and the port 3 with low insertion loss. Thus, reference may be made to FIG. 8 for the schematic structural diagram of the multi-port connection circuit shown in FIG. 3. A path (including the first switch and the first branch transmission line) corresponding to the first switch in FIG. 8 is equivalent to nonexistence.

Based on the embodiment shown in FIG. 3, a first phase shift network may be further added to a first port of the first switch. The first phase shift network may be a filter or a notch filter. It should be noted that both the filter and the notch filter may be implemented through a series and/or parallel capacitor or an inductor, where a network form may be a T-type network, an L-type network, a Π-type network, or a combination or cascading of the three network forms, as long as an unnecessary signal of the second frequency band may be suppressed through a necessary signal of the first frequency band, and a necessary impedance matching state is achieved while a frequency is gated. Optionally, a second phase shift network may be further added to a first port of the second switch. Reference may be made to description of the first phase shift network for a structure of the second phase shift network, as long as specific parameters of each element in the second phase shift network are not exactly same as those of the first phase shift network, and the second phase shift network gates a necessary signal of the second frequency band and suppresses an unnecessary signal of the first frequency band. A necessary impedance matching state is achieved while a frequency is gated. Reference may be made to FIG. 9 for details. The first phase shift network and the second phase shift network in FIG. 9 are both shown in a form of a Π-type network as an example. Optionally, the first phase shift network and the second phase shift network may be composed of elements having lumped parameters as shown in FIG. 9, or may be modular elements such as a surface acoustic wave (saw) filter and a modular notch filter. A specific form of the phase shift network is not limited by the embodiment of the disclosure. Optionally, the first phase shift network and the second phase shift network may exist simultaneously or may not exist simultaneously, as long as the first phase shift network and the second phase shift network may satisfy an impedance state of each port when a frequency needs to be gated.

The multi-port connection circuit shown in FIG. 9 may be used in a state in which the first switch and the second switch are both connected. Specifically, when the first end of the first switch and the second end of the first switch are connected and the first end of the second switch and the second end of the second switch are connected, a second end (that is, the port 2) of the first phase shift network and the second end (that is, the port 1) of the first common transmission line are in the impedance matching state in the first frequency band. The first phase shift network may be a filter or a notch filter whose passband includes the first frequency band and whose stop band includes the second frequency band. When the signal of the first frequency band flows through the signal path from the port 1 to the port 2, low insertion loss is caused, and the signal of the second frequency band is suppressed and fails to pass. A second end (the port 3) of the second phase shift network and the second end (that is, the port 1) of the first common transmission line are in an impedance matching state in the second frequency band. The second phase shift network may be a filter or a notch filter whose passband includes the second frequency band and whose stop band includes the first frequency band. When the signal of the second frequency band flows through the signal path from the port 1 to the port 3, low insertion loss is caused, and the signal of the first frequency band is suppressed and fails to pass. In the embodiment shown in FIG. 9, phase shift networks of corresponding frequencies are added to two paths respectively, such that the frequencies are gated when two switches are connected. Thus, the phase shift networks may be applied to a scene of concurrency of signals of the two paths, and for example, a scene of non-standalone (NSA) and a scene of carrier aggregation (CA). In the implementation, channels having different frequencies may be gated without introducing a switch, low insertion loss of a signal path is ensured while a switching scene of switches is simplified, and a use scene is expanded, such that the use scene is richer.

The embodiments conduct description with a case that the first switch and the second switch are single-pole multi-throw switches as an example. In the embodiments, the first end is not limited to the pin labeled with "1", or another pin, as long as the first end may be connected to a pin of the second end. When the multi-port connection circuit is applied to a radio frequency front-end module or another transceiver system, after the first end is selected as a switch, another unconnected end may be suspended, or may be connected to another signal path. This is not limited by the embodiment of the disclosure. It may be understood that if another unconnected end is connected to another signal path, for a frequency gated by the signal path, the impedance matching state of the port described in the embodiment may be used for gating signals of different frequencies, and ensure low insertion loss of the signal path. A corresponding phase shift network may be set in a path where a corresponding end is located according to a requirement of a path for frequency gating, and will not be repeated herein.

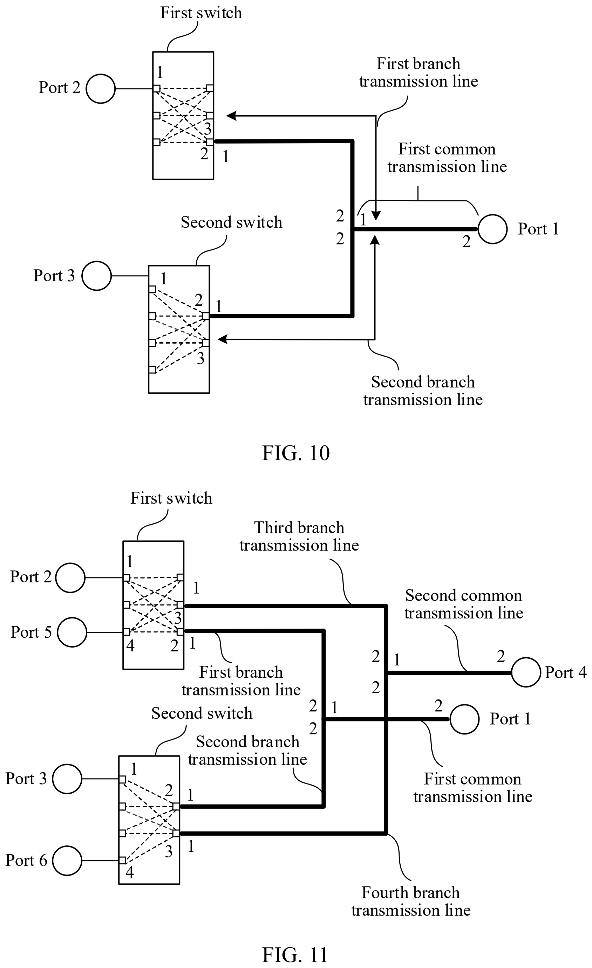

In some scenes, the first switch and/or the second switch may alternatively be a multi-pole multi-throw switch, and for example, a dual-pole dual-throw switch, a dual-pole three-throw switch, a dual-pole four-throw switch, a three-pole three-throw switch, a three-pole four-throw switch, or other switches having more ends and more channels. The first switch and the second switch may be same or not. FIG. 10 shows an example in which the first switch is a three-pole three-throw switch and the second switch is a dual-pole four-throw switch. As shown in FIG. 10, a third end (one end labeled with "3") of a first switch and a first end of the first switch are two ends that are capable of being connected. The third end of the first switch and a fourth end (one end labeled with "4") of the first switch are two ends that are capable of being connected. Optionally, a third end (one end labeled with "3") of a second switch and a first end of the second switch are two ends that are capable of being connected. The third end of the second switch and a fourth end (one end labeled with "4") of the second switch are two ends that are capable of being connected. Optionally, both unconnected ends of the first switch and the second switch may be connected to another signal path, to implement multi-channel switching.

When the first switch and/or the second switch are/is a multi-pole multi-throw switch, the multi-port connection circuit may further include: a third branch transmission line, a fourth branch transmission line, and a second common transmission line, as shown in FIG. 11. FIG. 11 is an example based on FIG. 10. A group of head-joint transmission lines including a third branch transmission line, a fourth branch transmission line and a second common transmission line are added to FIG. 11. Specifically, a third end of a first switch is connected to a first end of the third branch transmission line, and a third end of a second switch is connected to a first end of the fourth branch transmission line. A second end of the third branch transmission line and a second end of the fourth branch transmission line are both directly connected to a first end of the second common transmission line. Reference may be made to description of each embodiment about the first branch transmission line, the second branch transmission line and the first common transmission line for detailed description and interaction methods of the third branch transmission line, the fourth branch transmission line, and the second common transmission line, which will not be repeated herein. FIG. 11 shows an example in which a signal path where a third branch transmission line is located corresponds to a fourth port of a first switch, that is, a port 5 in FIG. 11, a signal path where a fourth branch transmission line is located corresponds to a fourth port of a second switch, that is, a port 6 in FIG. 11, and a second end of a second branch transmission line corresponds to a port 4 in FIG. 11. Actually, a third end of the first switch may alternatively be connected to a first end, and a third end of the second switch may alternatively be connected to a first end, as long as a corresponding port impedance state satisfies requirements for a gated frequency and low insertion loss.

In the multi-port connection circuit shown in FIG. 11, when the third end of the first switch and a fourth end of the first switch are connected and the third end of the second switch is disconnected, the fourth end of the first switch and a second end of a second common transmission line are in an impedance matching state in a third frequency band, and a fourth end of the second switch is in a high-impedance state in a fourth frequency band. When the third end of the first switch is disconnected and the third end of the second switch and the fourth end of the second switch are connected, if the fourth frequency band is a frequency band having an incomparable carrier wave length and transmission line size, the fourth end of the first switch is in a high-impedance state in the fourth frequency band. If the fourth end of the second switch and the second end of the second common transmission line are in an impedance matching state in the fourth frequency band, low insertion loss in gating and transmission of a signal of the fourth frequency band may be ensured. Reference may be made to description of a group of head-joint transmission lines included in FIG. 3 to FIG. 9 for a specific implementation principle and beneficial effects. Optionally, the third frequency band and a first frequency band may be same or not, and the fourth frequency band and a second frequency band may be same or not. This will not be repeated herein.

In the embodiment shown in FIG. 11, when the third end of the first switch is disconnected and the third end of the second switch and the fourth end of the second switch are connected, if the fourth frequency band is a frequency band having a comparable carrier wave length and transmission line size, a difference between a sum of an electrical length of the third branch transmission line, an electrical length of the fourth branch transmission line, and an equivalent phase shift of the first switch and a third value is smaller than or equal to a third preset error threshold. The third value is a sum of an integer multiple of a carrier wave length corresponding to the fourth frequency band and a quarter of the carrier wave length. Alternatively, a difference between two times of an electrical length of the third branch transmission line and a fourth value is smaller than or equal to a fourth preset error threshold, a difference between two times of a sum of an electrical length of the fourth branch transmission line and an equivalent phase shift of the first switch and the fourth value is smaller than or equal to the fourth preset error threshold, and the fourth value is a positive integer multiple of a second carrier wave length corresponding to the fourth frequency band. That is, the electrical length of the third branch transmission line, an electric field of the fourth branch transmission line and the carrier wave length of the fourth frequency band may satisfy any group of relationships in the formula (6) and the formula (8). Adaptively, an electrical length of the first branch transmission line may be correspondingly changed to the electrical length of the third branch transmission line, an electrical length of the second branch transmission line may be correspondingly changed to the electrical length of the fourth branch transmission line, and a carrier wave length corresponding to the second frequency band may be changed to the carrier wave length corresponding to the fourth frequency band. Thus, gating and low insertion loss of a high-frequency signal of the fourth frequency band are satisfied. Reference may be made to detailed description of the formula (6) and the formula (8) for a specific implementation principle and beneficial effects, which will not be repeated herein.

The third preset error threshold and the fourth preset error threshold may be same or not. Both the third preset error threshold and the fourth preset error threshold may be small, and for example, may be $\pm 0.5$, $\pm 0.1$, $\pm 0.01$, $\pm 0.05$, etc. Specific values of the third preset error threshold and the fourth preset error threshold are not limited by the embodiment of the disclosure. Moreover, the third preset error threshold and the fourth preset error threshold may be same as or different from the first preset error threshold and the second preset error threshold described above, and are not limited by the embodiment of the disclosure.

In some embodiments, the structure shown in FIG. 11 may be further used for a dual-antenna switching scene, and for example, a TAS or MIMO scene, such that application scenes of a multi-port connection circuit are richer. Specifically, a fifth frequency band may include two transmission paths under service of dual-antenna TAS. A first transmission path includes: the first end of the first switch, the second end of the first switch, the first branch transmission line, and the first common transmission line. That is, a transmission signal of the fifth frequency band may flow through the second end of the first switch from the first end of the first switch, and may reach an antenna or other switches after passing the first branch transmission line and the first common transmission line. A second transmission path may include: the first end of the first switch, the third end of the first switch, the third branch transmission line, and the second common transmission line. That is, a transmission signal of the fifth frequency band may alternatively flow through the third end of the first switch from the first end of the first switch, and may reach another antenna after passing the third branch transmission line and the second common transmission line.

If the fifth frequency band is in a reception state of MIMO, the fifth frequency band may further include two reception paths. A first reception path includes: the first common transmission line, the second branch transmission line, the second end of the second switch, and the first end of the second switch. That is, a reception signal of the fifth frequency band may be received by one antenna, and sequentially flow through the first common transmission line, the second branch transmission line, the second end of the second switch, and the first end of the first switch. In addition, a second reception path includes: the second common transmission line, the fourth branch transmission line, the third end of the second switch, and the fourth end of the second switch. That is, a reception signal of the fifth frequency band may alternatively be received by another antenna, and sequentially flow through the second common transmission line, the fourth branch transmission line, the third end of the second switch, and the fourth end of the second switch.

Optionally, the fifth frequency band may be a same frequency band as any one of the first frequency band, the second frequency band, the third frequency band, or the fourth frequency band, or may be a different frequency band, and is not limited by the embodiment of the disclosure. The first end and the fourth end of the first switch in the two transmission paths of the fifth frequency band are not limited to the first end and the fourth end, and may be ports connected to the second end and the third end in the first switch. Specifically, adjustment may be conducted according to a design of the entire circuit, and is not limited by the embodiment.

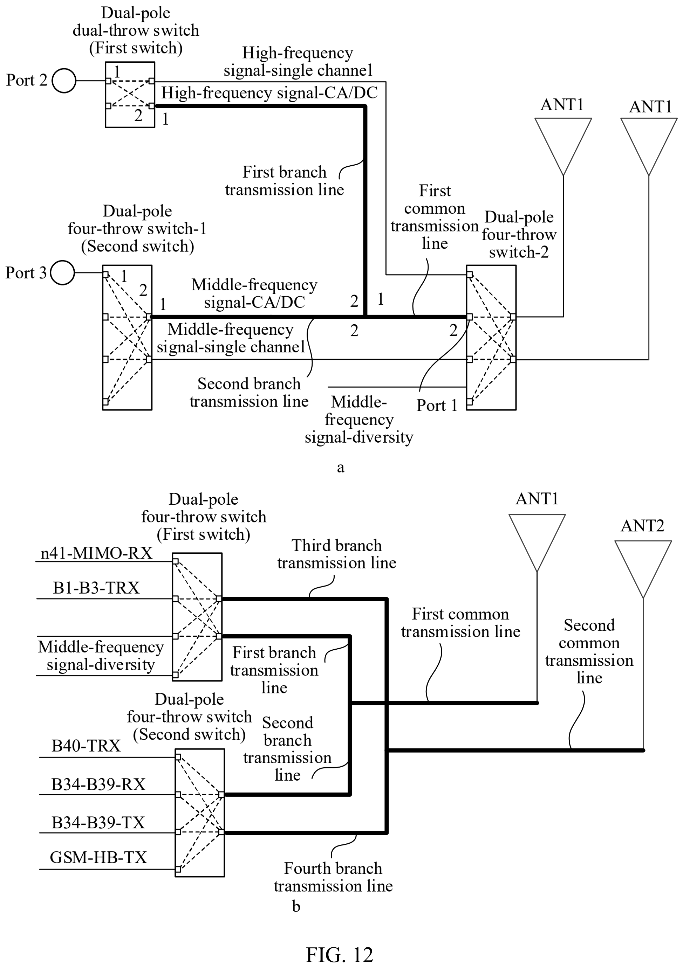

Then, a case that the multi-port connection circuit provided by the embodiment of the disclosure is applied to an actual circuit is described. Specifically, with the circuit shown in FIG. a of FIG. 2 as an example, after the multi-port connection circuit is introduced, a structure of an original circuit changes. Reference may be made to FIG. a of FIG. 12. Compared with FIG. a of FIG. 2, combiners are reduced. That is, if a high-frequency signal or a middle-frequency signal in a carrier aggregation (CA) state or a dual-connectivity (DC) state needs to reach an antenna 1 (ANT1) or an antenna 2 (ANT2) via two stages of switches without passing a combiner. When a high-frequency signal and a middle-frequency signal may be gated by different signal paths in a case that a port impedance state satisfies a requirement, low insertion loss is achieved, a circuit is simplified, and cost is reduced. Further, with the circuit shown in FIG. b of FIG. 2 as an example, after the multi-port connection circuit is introduced, a structure of an original circuit changes. Specifically, reference may be made to FIG. b of FIG. 12. In FIG. b of FIG. 12, a GSM high-frequency transmission signal (GSM_HB_TX) and signals of B34, B39 and B40 frequency bands may be connected to an antenna only through one switch. Compared with FIG. b of FIG. 2, one switch is reduced on paths of the GSM high-frequency transmission signal and the signals of the B34, B39 and B40 frequency bands. Thus, when a high-frequency signal and a middle-frequency signal may be gated by different signal paths in a case that a port impedance state satisfies a requirement, low insertion loss is caused, and the circuit is simplified.

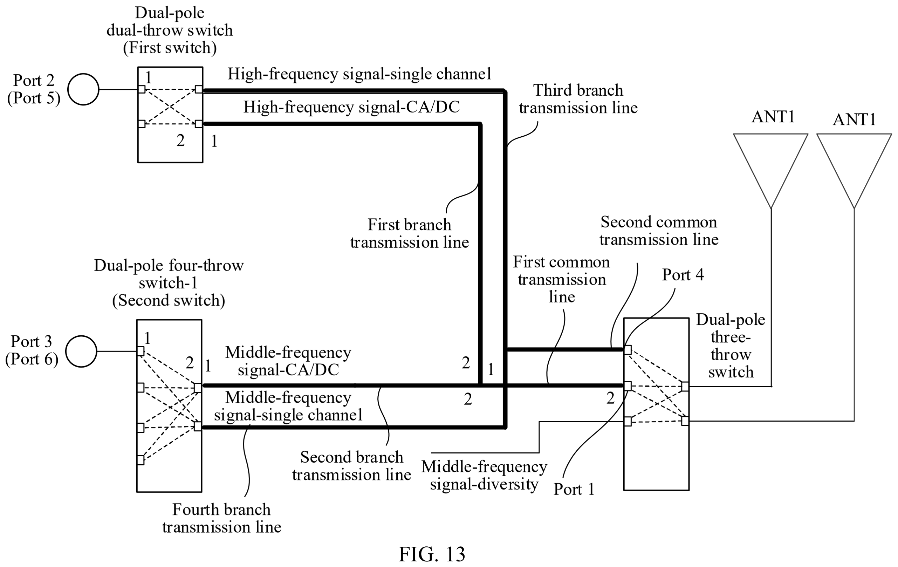

Based on the embodiment shown in FIG. a of FIG. 12, reference may be made to FIG. 13 for a method for using a group of head-joint transmission lines for signal paths of a single-channel high-frequency signal and a single-channel middle-frequency signal. FIG. 13 shows an example in which a port 2 and a port 5 correspond to terminals of a same switch, and a port 3 and a port 6 correspond to terminals of a same switch. As shown in FIG. 13, if another group of head-joint transmission lines are introduced, an original dual-pole four-throw switch-2 may be changed to a dual-pole three-throw switch. It should be noted that when a design and a technology of the switch are same, generally, a larger number of switch ports indicate higher insertion loss, and a smaller number of switch ports indicate lower insertion loss. In the circuit shown in FIG. 13, because one more group of head-joint transmission lines are introduced, a number of switch ports is reduced, and insertion loss of an entire signal path can be reduced.

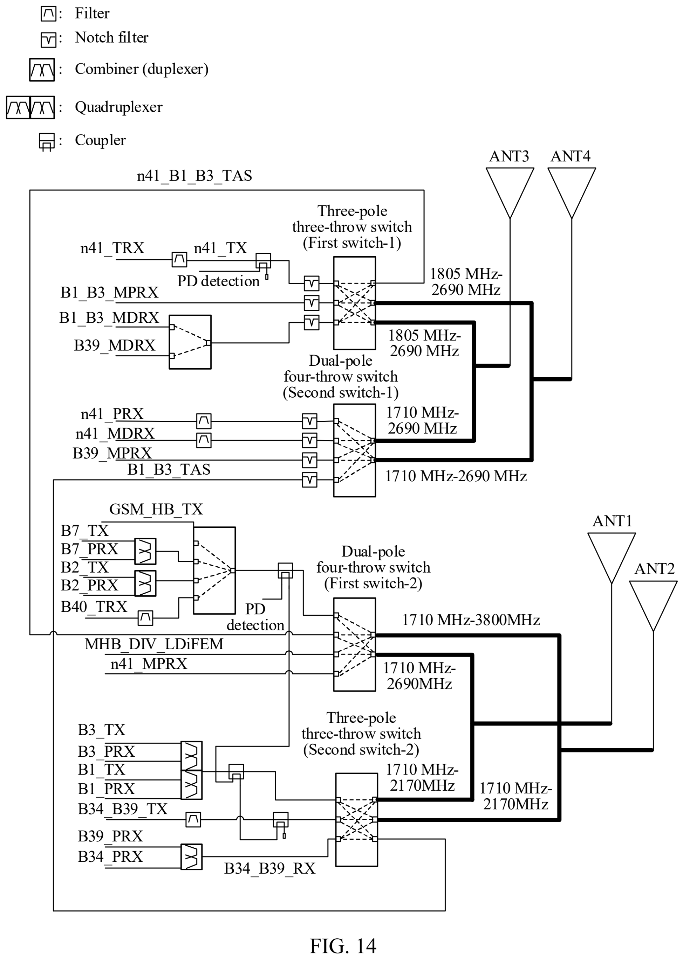

When the multi-port connection circuit is applied to a radio frequency front-end module, reference may be made to FIG. 14 for a circuit diagram of a related part. Firstly, functions and labeled identifiers of all elements shown in FIG. 14 are described. Generally, a filter appearing in a signal path of a radio frequency signal may filter a signal that needs to pass the signal path, that is, a signal of an unnecessary frequency is filtered out, and a signal of a necessary frequency is reserved. A notch filter may suppress a signal that needs to be suppressed and enable signals of other necessary frequencies to pass. A coupler may be configured to couple a signal on a main path and conduct power detection on the signal obtained through coupling, to implement power detection (PD) of the signal on the main path. Generally, couplers on a plurality of different signal paths may be further connected to each other, and share a power detection port. In FIG. 14, TX represents a transmission path, RX represents a reception path, PRX denotes a main set reception path, DRX denotes a diversity reception path, M represents a multiple-input multiple-output (MIMO) path, B represents a band, MB represents a middle band signal, HB represents a high band signal, GSM represents a signal path of a global system for mobile communication (GMS) standard, DIV represents a diversity signal path, and MHBLDiFEM represents a middle-high frequency diversity module. In a duplexer, two discrete ends may gate signals of two different frequencies, and a common end may enable signals of different frequencies to pass. Four discrete ends of a quadruplexer may gate signals of four different frequencies respectively, and a common end may enable signals of different frequencies to pass. Transmit antenna selection (TAS) represents a signal path used in a scene of smart antenna selection. In the diagram shown in FIG. 14, transmission lines shown by thick black lines are head-joint transmission lines in the multi-port connection circuit described in the disclosure. FIG. 14 shows four groups of head-joint transmission lines. Originally, frequency gating or path gating is implemented for each group of head-joint transmission lines through a single-pole dual-throw switch, or frequency gating or path gating may be implemented for a plurality of groups of head-joint transmission lines through a multi-pole multi-throw switch. After the technical solution of the disclosure is used, a plurality of single-pole dual-throw switches or multi-pole multi-throw switches do not need to be used, thus reducing introduction of switching elements. Then, signal flows of the circuit shown in FIG. 14 in different working states are described, to indicate that FIG. 14 does not reduce a specification of an original circuit while reducing path insertion loss.

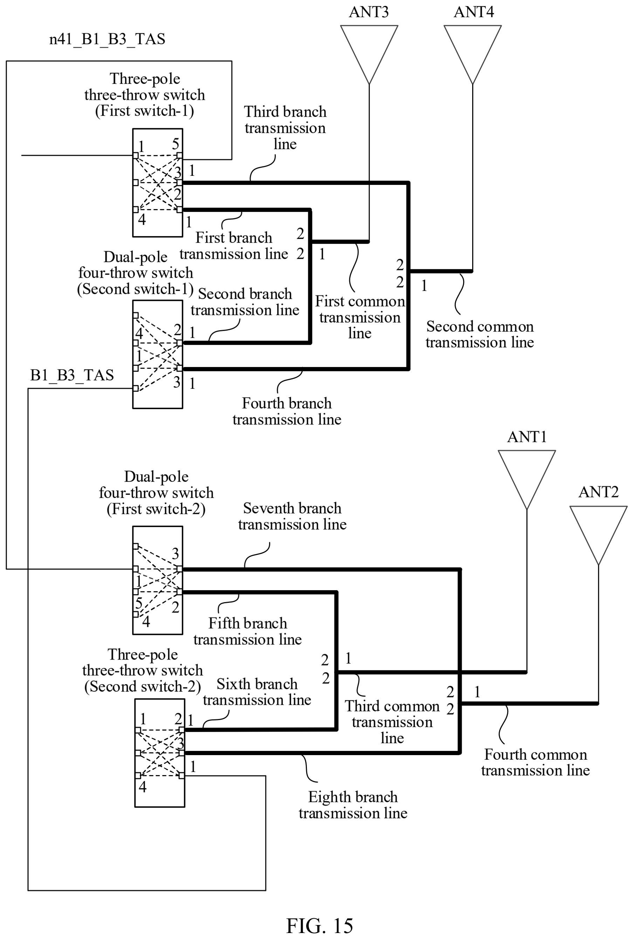

To clearly describe a signal flow direction under TAS service, unrelated elements and connection lines in FIG. 14 may be simplified. Reference may be made to FIG. 15 for a schematic diagram of a simplified circuit structure. FIG. 15 may be considered as including two groups of multi-port connection circuits shown in FIG. 11. For example, a second group of multi-port connection circuit may be added based on the multi-port connection circuit shown in FIG. 11.

The second group of multi-port connection circuits includes: a third switch (a first switch-2 in FIG. 15), a fourth switch (a second switch-2 in FIG. 15), a fifth branch transmission line, a sixth branch transmission line, a seventh branch transmission line, an eighth branch transmission line, a third common transmission line, and a fourth common transmission line. A first end of the third switch and a second end of the third switch are two ends that are capable of being connected. A first end of the fourth switch and a second end of the fourth switch are two ends that are capable of being connected. The second end of the third switch is connected to a first end of the fifth branch transmission line. The second end of the fourth switch is connected to a first end of the sixth branch transmission line. A second end of the fifth branch transmission line and a second end of the sixth branch transmission line are both directly connected to a first end of the third common transmission line. A third end of the third switch and a fourth end of the third switch are two ends that are capable of being connected. A third end of the fourth switch and a fourth end of the fourth switch are two ends that are capable of being connected. The third end of the third switch is connected to a first end of the seventh branch transmission line. The third end of the fourth switch is connected to a first end of the eighth branch transmission line. A second end of the seventh branch transmission line and a second end of the eighth branch transmission line are both directly connected to a first end of the fourth common transmission line.

In FIG. 15, two groups of multi-port connection circuits may implement dual-antenna switching separately. Reference may be made to description of FIG. 11 during working in a fifth frequency band for details, which will not be repeated herein. The two groups of multi-port connection circuits in FIG. 15 may be further combined into an integral multi-port connection circuit, to implement four-antenna switching, and for example, a scene of four-antenna TAS service and four-antenna MIMO. Specifically, the first switch further has a fifth end, and the first end of the first switch and the fifth end of the first switch are two ends that are capable of being connected. The fifth end of the first switch is connected to the first end of the third switch.

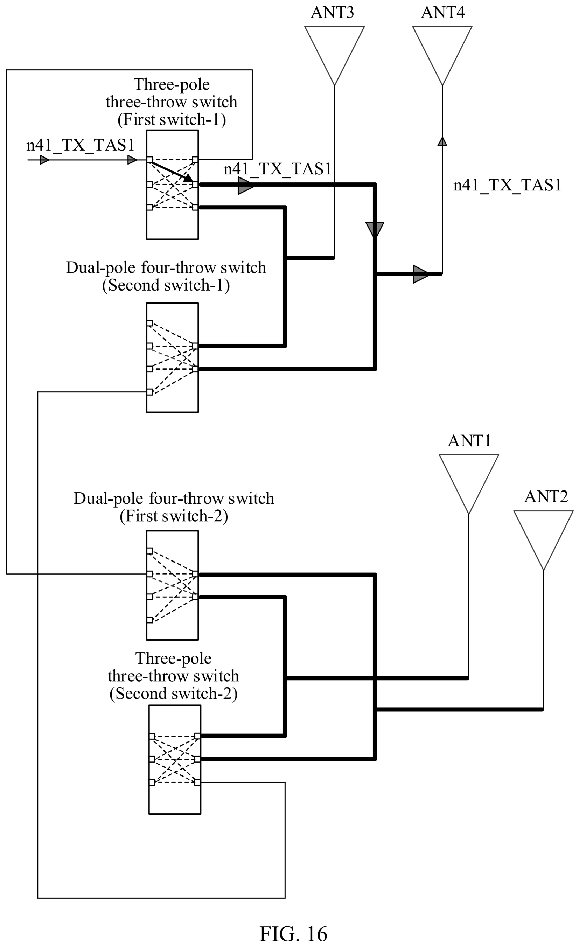

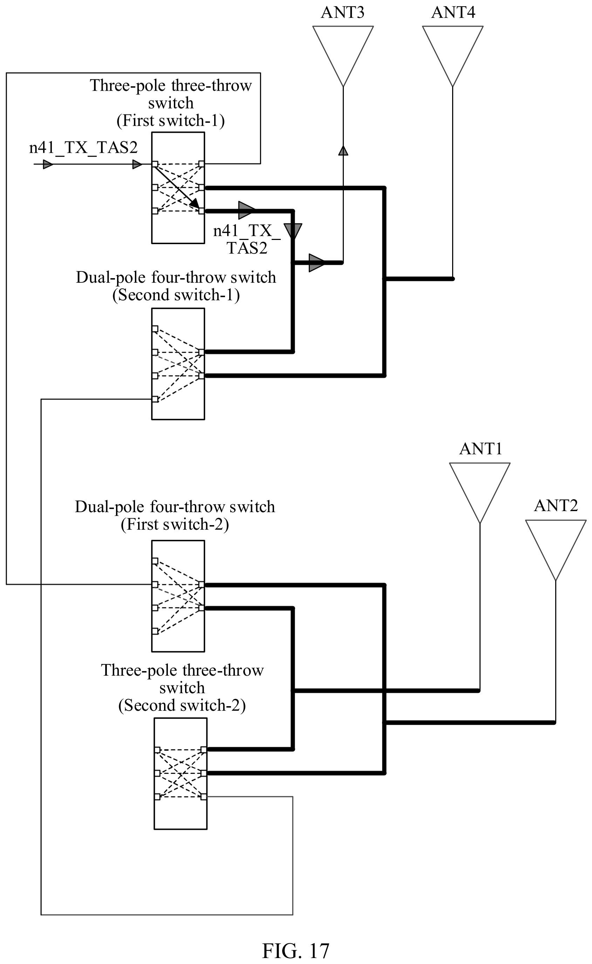

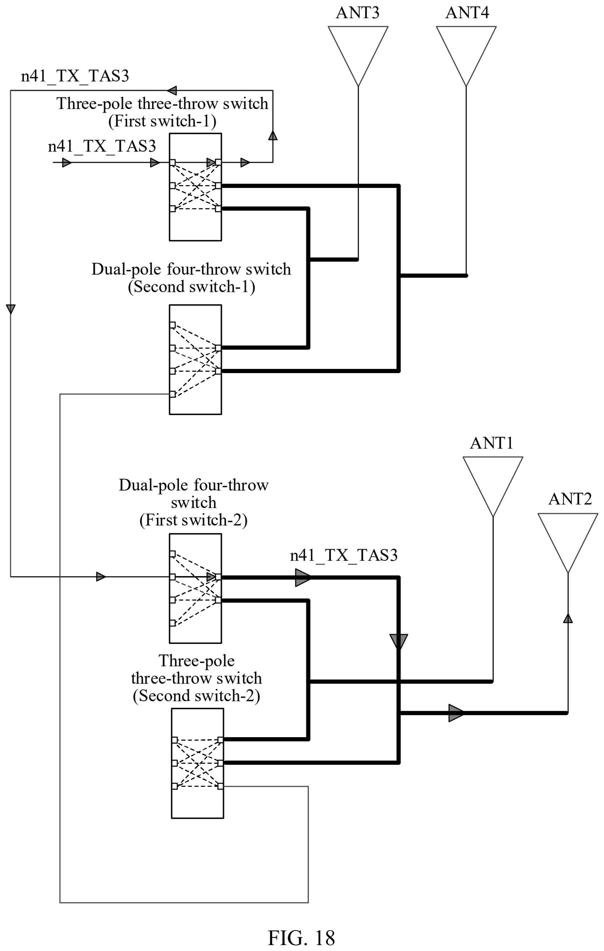

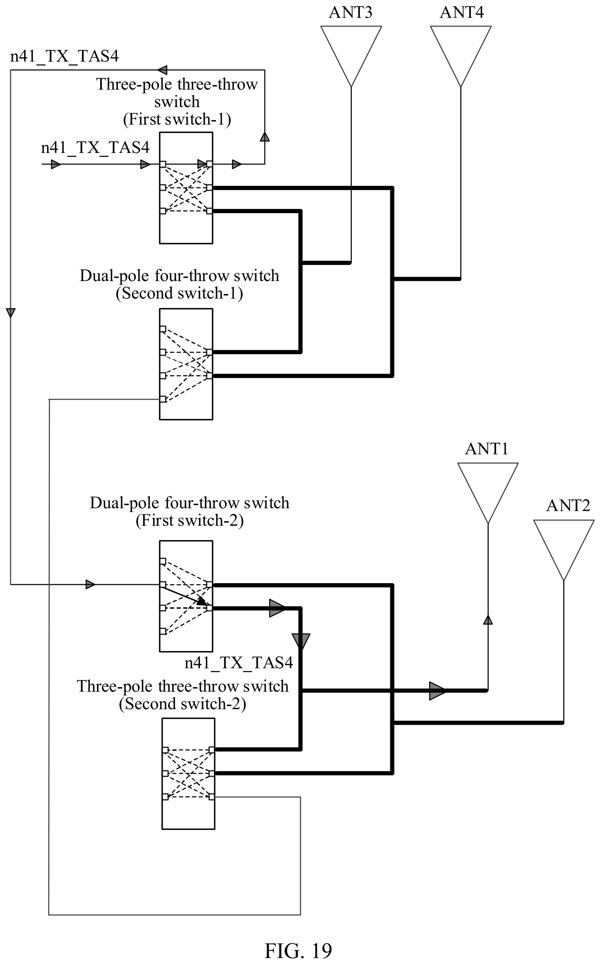

In FIG. 15, reference may be made to FIG. 17 and FIG. 16 for a first transmission path (n41_TX_TAS2) and a second transmission path (n41_TX_TAS1) of the fifth frequency band. A third transmission path (n41_TX_TAS4) may be further added to the fifth frequency band and includes: the first end of the first switch, the fifth end of the first switch, the first end of the third switch, the second end of the third switch, the fifth branch transmission line, and the third common transmission line. Meanwhile, a fourth transmission path (n41_TX_TAS4) may be further added to the fifth frequency band and includes: the first end of the first switch, the fifth end of the first switch, the first end of the third switch, the third end of the third switch, the seventh branch transmission line, and the fourth common transmission line. Reference may be made to FIG. 19 and FIG. 18 for details.

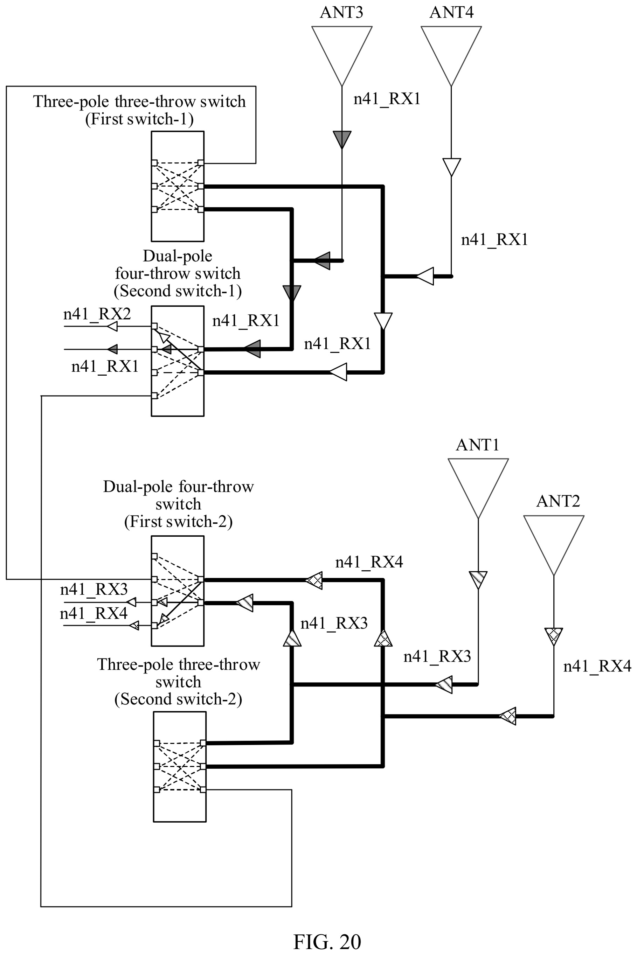

In FIG. 15, reference may be made to FIG. 20 for a first reception path (n41_RX1) and a second reception path (n41_RX2) of the fifth frequency band. A third reception path may be further added to the fifth frequency band and includes: the third common transmission line, the sixth branch transmission line, the second end of the fourth switch, and the first end of the fourth switch. In addition, a fourth reception path of the fifth frequency band includes: the fourth common transmission line, the eighth branch transmission line, the third end of the fourth switch, and the fourth end of the fourth switch. It should be noted that the first end of the fourth switch and the fourth end of the fourth switch may alternatively be other ports of the fourth switch, as long as the ports may be connected to the second end and the third end of the fourth switch respectively.

Optionally, the third reception path of the fifth frequency band may further include: the third common transmission line, the fifth branch transmission line, the second end of the third switch, and a fifth end of the third switch. The fourth reception path of the fifth frequency band includes: the fourth common transmission line, the seventh branch transmission line, the third end of the third switch, and the fourth end of the third switch. It should be noted that the fourth end of the third switch and the fifth end of the third switch herein may alternatively be other ports of the third switch, as long as the ports may be connected to the second end and the third end of the third switch respectively.

In the multi-port connection circuit shown in FIG. 15, with n41 as the fifth frequency band as an example, a scene of four-antenna TAS service and four-antenna MIMO of a sixth frequency band may also be compatible. Then, based on the schematic circuit diagram shown in FIG. 15, with B1 or B3 (denoted by B1/B3) as the sixth frequency band an example, signal flow directions in a scene of multi-antenna switching of n41 and B1/B3 are described.

In FIG. 15, an n41 frequency band may implement the four-antenna TAS service, and reference may be made to paths indicated by arrows shown in FIG. 16, FIG. 17, FIG. 18 and FIG. 19 for four transmission paths. As shown in FIG. 16, in a first n41 signal path indicated by n41_TX_TAS1, after passing the multi-port connection circuit, a transmission signal of an n41 frequency band reaches an antenna 4 (ANT4), and a signal of the n41 frequency band is transmitted through the ANT4. As shown in FIG. 17, in a second n41 signal path indicated by n41_TX_TAS2, after passing the multi-port connection circuit, a transmission signal of an n41 frequency band reaches an antenna 3 (ANT3), and a signal of the n41 frequency band is transmitted through the ANT3. As shown in FIG. 18, in a third n41 signal path indicated by n41_TX_TAS3, after passing the multi-port connection circuit, a transmission signal of an n41 frequency band reaches an antenna 2 (ANT2), and a signal of the n41 frequency band is transmitted through the ANT2. As shown in FIG. 19, in a fourth n41 signal path indicated by n41_TX_TAS4, after passing the multi-port connection circuit, a transmission signal of an n41 frequency band reaches an antenna 1 (ANT1), and a signal of the n41 frequency band is transmitted through the ANT1.

FIG. 20 is a schematic diagram of four reception paths of n41 in an MIMO scene. The four reception paths are denoted by n41_RX1, n41_RX2, n41_RX3, and n41_RX4, respectively.

FIG. 16 to FIG. 20 indicate that after the multi-port connection circuit is introduced into the radio frequency front-end module, path switching functions of TAS service and MIMO service of n41 are not influenced. Because introduction of a switch is reduced, complexity of antenna switching can be simplified, transmission performance of the TAS service and the MIMO service can be improved, and meanwhile, loss of a signal path can be reduced.

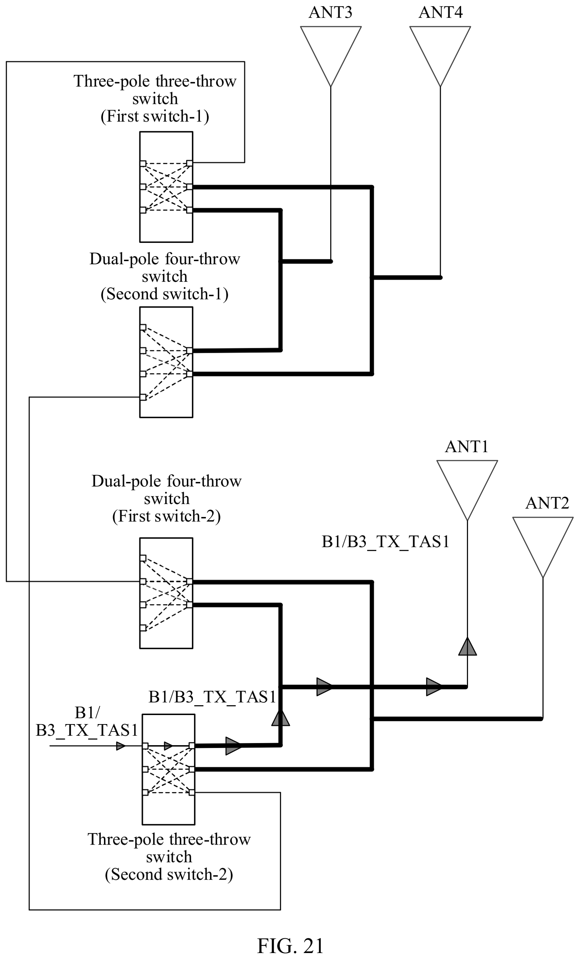

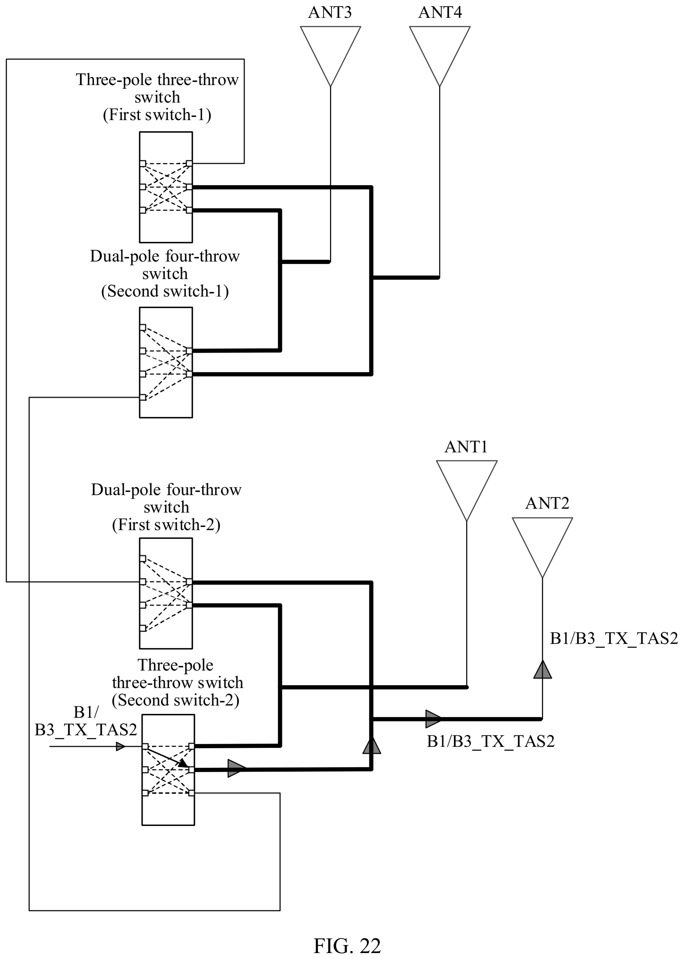

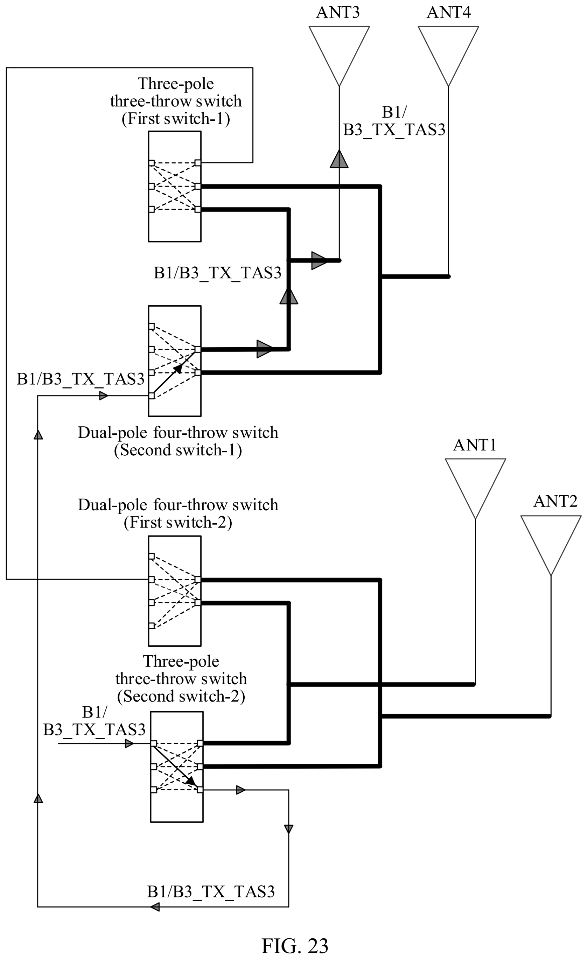

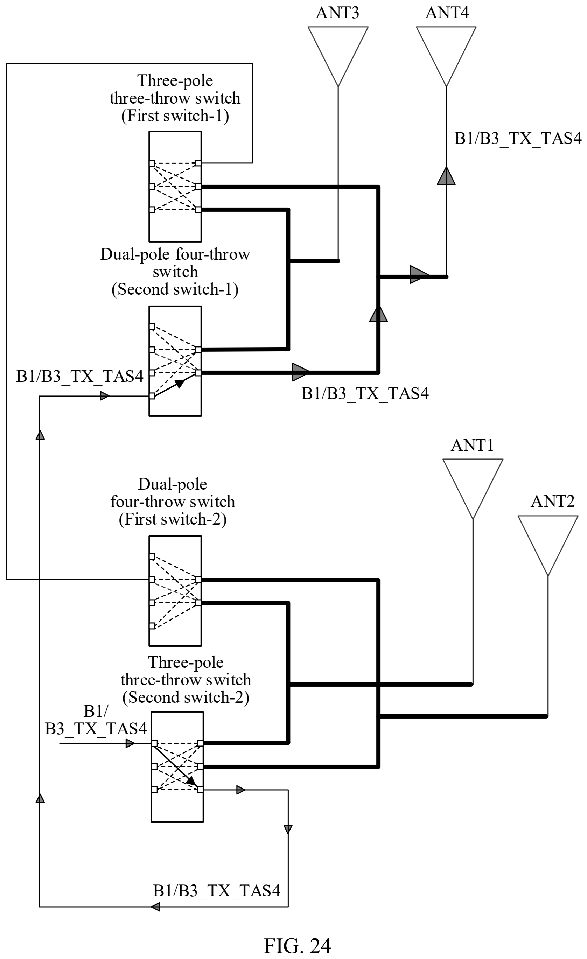

In the circuit shown in FIG. 14 and FIG. 15, B1 and B3 frequency bands may implement the four-antenna TAS service, and reference may be made to paths indicated by arrows shown in FIG. 21, FIG. 22, FIG. 23 and FIG. 24 for four transmission paths. As shown in FIG. 21, in a first B1/B3 (representing B1 or B3) signal path indicated by B1/B3_TX_TAS1, after passing the multi-port connection circuit, a transmission signal of a B1/B3 frequency band reaches an ANT1, and a signal of the B1/B3 frequency band is transmitted through the ANT1. As shown in FIG. 22, in a second B1/B3 signal path indicated by B1/B3_TX_TAS2, after passing the multi-port connection circuit, a transmission signal of a B1/B3 frequency band reaches an ANT2, and a signal of the B1/B3 frequency band is transmitted through the ANT2. As shown in FIG. 23, in a third B1/B3 signal path indicated by B1/B3_TX_TAS3, after passing the multi-port connection circuit, a transmission signal of a B1/B3 frequency band reaches an ANT3, and a signal of the B1/B3 frequency band is transmitted through the ANT3. As shown in FIG. 24, in a fourth B1/B3 signal path indicated by B1/B3_TX_TAS4, after passing the multi-port connection circuit, a transmission signal of a B1/B3 frequency band reaches an ANT4, and a signal of the B1/B3 frequency band is transmitted through the ANT4.

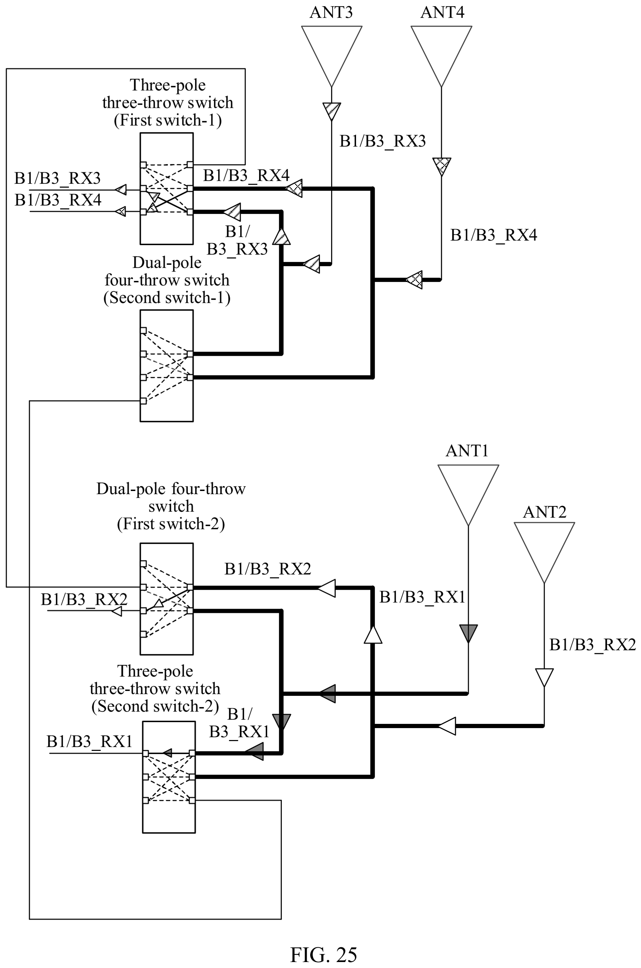

FIG. 25 is a schematic diagram of four reception paths of B1/B3 in an MIMO scene. The four reception paths are denoted by B1/B3_RX1, B1/B3_RX2, B1/B3_RX3, and B1/B3_RX4, respectively. The reception signal of B1/B3 may enter a quadruplexer shown in FIG. 14 to gate different signal channels, and will not be repeated herein.

FIG. 21 to FIG. 25 indicate that after the multi-port connection circuit is introduced into the radio frequency front-end module, path switching functions of TAS service and MIMO service of B1/B3 are not influenced. Introduction of a switch is reduced, such that complexity of antenna switching can be simplified, transmission performance of the TAS service and the MIMO service can be improved, and meanwhile, loss of a signal path can be reduced.

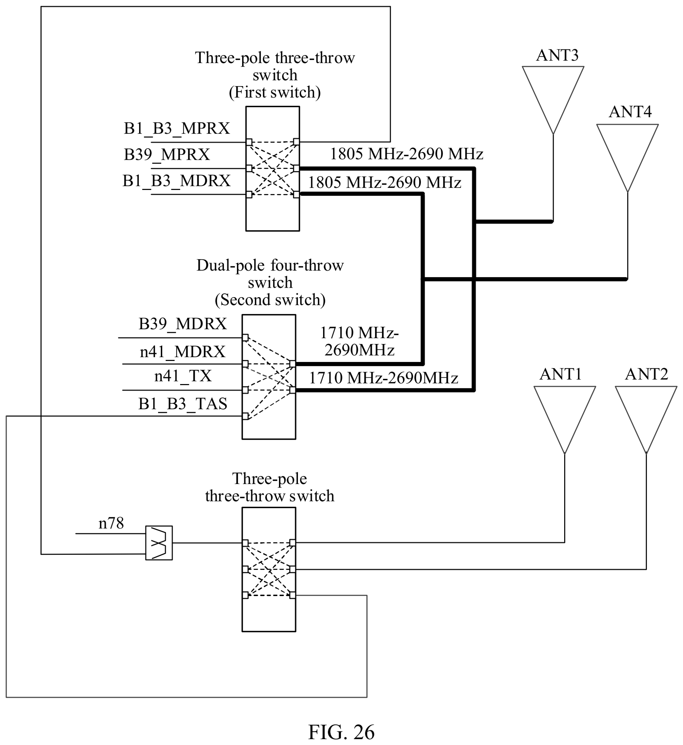

FIG. 26 shows a schematic structural diagram of a partial circuit, applied to a radio frequency front-end module, of an illustrative multi-port connection circuit according to an embodiment of the disclosure. It should be noted that reference may be made to meanings of icons and labels of elements in FIG. 26 for description in FIG. 14, which will not be repeated herein. In FIG. 26, an ANT3 may be used as an antenna used in an MIMO scene of a middle-frequency signal (of a frequency band such as B1\B3). An ANT4 may be used as an antenna used for a middle-frequency signal (of a frequency band such as B1\B3), a high-frequency signal (of a frequency band such as B7), and a frequency band (for example, n41) of 5G communication. An ANT1 may be used as a main set antenna used for a middle-frequency signal (of a frequency band such as B1\B3) and a high-frequency signal (of a frequency band such as B7), or used as an antenna of an n78 frequency band. An ANT2 may be used as a diversity antenna used for a middle-frequency signal (of a frequency band such as B1\B3) and a high-frequency signal (of a frequency band such as B7).

In the partial circuit of the radio frequency front-end module shown in FIG. 26, after the multi-port connection circuit is introduced, a path switching function in various scenes is not influenced, such that the circuit can be simplified, and path loss can be reduced.

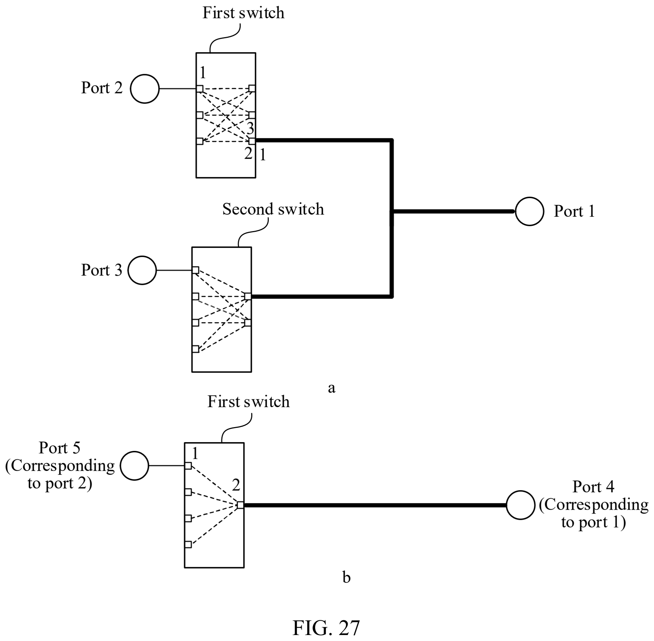

FIG. 27 shows an equivalent circuit diagram of an illustrative multi-port connection circuit according to an embodiment of the disclosure.

A structure of the multi-port connection circuit of the embodiment of the disclosure and an application of the multi-port connection circuit to the radio frequency front-end module are described in detail above. Quantization of insertion loss reduction of the multi-port connection circuit is described below with reference to simulation parameters.

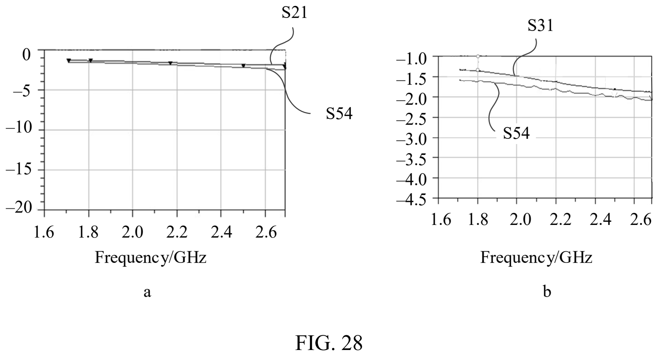

Reference may be made to an equivalent circuit diagram of the multi-port connection circuit shown in FIG. 27 for details. FIG. a of FIG. 27 is a schematic structural diagram of an actual multi-port connection circuit. When a signal of a first frequency band is transmitted from a port 1 to a port 2, in an ideal state, FIG. a of FIG. 27 may be equivalent to the circuit diagram shown in FIG. b of FIG. 27. To clearly compare S parameters, an original port 1 in the equivalent circuit diagram may be changed to a port 4, and an original port 2 in the equivalent circuit diagram may be changed to a port 5. A curve graph of the S parameters is obtained through simulation. Reference may be made to FIG. 28. It may be seen from FIG. 28 that, an increase in insertion loss of an actual circuit shown in FIG. 27 is smaller than that of an ideal circuit. A specific value may be described through reading of labeling points. Specific values of labeling points of all frequency points of the S parameters may be sorted into parameters in Table 1.

Table 1

| Frequency (MHz) | S21 (dB) | S54 (dB) | Insertion loss benefit (dB) |
|---|---|---|---|
| 1710 | 1.5 | 1.3 | -0.2 |
| 1810 | 1.6 | 1.4 | -0.2 |

(continued)

| Frequency (MHz) | S21 (dB) | S54 (dB) | Insertion loss benefit (dB) |
|---|---|---|---|
| 2170 | 1.8 | 1.6 | -0.2 |
| 2500 | 2.3 | 1.8 | -0.5 |
| 2690 | 2.5 | 1.9 | -0.6 |
| Frequency (MHz) | S31 (dB) | S54 (dB) | Insertion loss benefit (dB) |
| 1710 | 1.5 | 1.3 | -0.2 |
| 1810 | 1.6 | 1.4 | -0.2 |
| 2170 | 1.8 | 1.6 | -0.2 |
| 2500 | 2.0 | 1.8 | -0.2 |
| 2690 | 2.1 | 1.9 | -0.2 |

With reference to FIG. 28, in Table 1, S21 denotes insertion loss of different frequency points when a signal is transmitted on a signal path from a port 1 to a port 2, and is 1.5 dB, 1.6 dB, 1.8 dB, 2.3 dB, and 2.5 dB at 1710 MHz, 1810 MHz, 2170 MHz, 2500 MHz, and 2690 MHz, respectively. S54 denotes insertion loss of different frequency points when a signal is transmitted on a signal path from a port 5 to a port 4, and is 1.3 dB, 1.4 dB, 1.6 dB, 1.8 dB, and 1.9 dB at 1710 MHz, 1810 MHz, 2170 MHz, 2500 MHz, and 2690 MHz, respectively. In a common switch, insertion loss is higher than 0.3 dB in a frequency band of 2170 MHz or below, and insertion loss is generally close to 1 dB in a frequency band of 2500 MHz or above. It may be seen that, for 2170 MHz or below, insertion loss on a common transmission line is increased by 0.2 dB, such that high insertion loss higher than 0.3 dB caused by introduction of a switch may be avoided. For 2500 MHz or above, insertion loss on a common transmission line is increased by 0.5 dB or 0.6 dB, such that high insertion loss close to 1 dB caused by introduction of a switch may be avoided. The technical solution of the embodiment of the disclosure produces obvious benefits.

Similarly, if a signal is transmitted on a signal path of the port 1 and the port 3, reference may be made to data in S31. It may be seen that, insertion loss on a common transmission line is increased by 0.2 dB, such that high insertion loss caused by introduction of a switch may be avoided and produces obvious benefits, and the insertion loss can be reduced while signals of different frequencies are gated.

An embodiment of the disclosure further provides a radio frequency front-end module. The radio frequency front-end module includes one or more multi-port connection circuits according to any one of the embodiments.

An embodiment of the disclosure further provides an electronic device. The electronic device includes one or more multi-port connection circuits according to any one of the embodiments.

An embodiment of the disclosure further provides an electronic device. The electronic device includes the radio frequency front-end module according to any one of the embodiments.

Reference may be made to related description about the multi-port connection circuit for a related implementation principle and technical effects of the radio frequency front-end module and the electronic device provided by the embodiment, which will not be repeated herein.

In several embodiments according to the disclosure, it should be understood that the disclosed apparatus and method may be implemented in other manners. For example, the apparatus embodiment is merely illustrative. For example, module or unit division is merely logical function division and may be another division during actual implementation. For example, a plurality of units or components may be combined or integrated into another apparatus, or some features may be omitted or not performed. Moreover, mutual coupling or direct coupling or communication connection shown or discussed may be indirect coupling or communication connection through some interfaces, apparatuses or units. The changed units may or may not be physically separated. A part displayed as a unit may be one physical unit or a plurality of physical units. The units may be located at one position or may be distributed at different positions. Some units or all the units may be selected according to actual needs, to achieve the objective of the solution of the embodiment.

In addition, each functional unit in each embodiment of the disclosure may be integrated in one processing unit, or each unit may exist separately and physically, or two or more units may be integrated in one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions of the embodiments of the disclosure essentially, or the part contributing to the prior art, or all or some technical solutions may be implemented in a form of a software product. The software product is stored in a storage medium and includes several instructions for instructing a device (which may be a single-chip microcomputer, a chip, etc.)

or a processor to perform all or some steps of the method according to all the embodiments of the disclosure. The storage medium includes: a USB flash disk, a mobile hard disk, a read only memory (ROM), a random access memory (RAM), a magnetic disk, an optical disk, and other media capable of storing program codes.

What are described above are merely specific implementations of the disclosure, and are not intended to limit the protection scope of the disclosure. Any changes or substitutions that can be easily made by those skilled in the art within the scope of the technology disclosed in the disclosure should fall within the protection scope of the disclosure. Thus, the protection scope of the disclosure should be subject to the protection scope of the claims.

**Claims**

1.  A multi-port connection circuit, comprising: a first switch, a second switch, a first branch transmission line, a second branch transmission line, and a first common transmission line, wherein

    a first end of the first switch and a second end of the first switch are two ends that are capable of being connected, and a first end of the second switch and a second end of the second switch are two ends that are capable of being connected;
    the second end of the first switch is connected to a first end of the first branch transmission line, and the second end of the second switch is connected to a first end of the second branch transmission line;
    a second end of the first branch transmission line and a second end of the second branch transmission line are both directly connected to a first end of the first common transmission line; and
    when the first end of the first switch and the second end of the first switch are connected and the second end of the second switch is disconnected, the first end of the first switch and a second end of the first common transmission line are in an impedance matching state in a first frequency band, and the first end of the second switch is in a high-impedance state in the first frequency band.

2.  The multi-port connection circuit according to claim 1, wherein when the second end of the first switch is disconnected and the first end of the second switch and the second end of the second switch are connected, the first end of the first switch is in a high-impedance state in a second frequency band, and the first end of the second switch and the second end of the first common transmission line are in an impedance matching state in the second frequency band.

3.  The multi-port connection circuit according to claim 1 or 2, wherein the impedance matching state is a state in which a port has matched impedance of fifty ohm; and/or,
    the high-impedance state is a state in which a reflection coefficient of a port is larger than a preset threshold.

4.  The multi-port connection circuit according to any one of claims 1 to 3, wherein the first switch is a single-pole multi-throw switch, and the second end of the first switch and any one of the other ends of the first switch are two ends that are capable of being connected; and/or,
    the second switch is a single-pole multi-throw switch, and the second end of the second switch and any one of the other ends of the second switch are two ends that are capable of being connected.

5.  The multi-port connection circuit according to any one of claims 1 to 4, wherein the second frequency band is a frequency band of a signal passing the first common transmission line and the second branch transmission line, and a frequency of the second frequency band is higher than that of the first frequency band; and

    when the second end of the first switch is disconnected and the first end of the second switch and the second end of the second switch are connected, a difference between a sum of an electrical length of the first branch transmission line, an electrical length of the second branch transmission line and an equivalent phase shift of the first switch and a first value is smaller than or equal to a first preset error threshold, and the first value is a sum of an integer multiple of a first carrier wave length corresponding to the second frequency band and a quarter of the first carrier wave length; or,
    a difference between two times of an electrical length of the first branch transmission line and a second value is smaller than or equal to a second preset error threshold, a difference between two times of a sum of an electrical length of the second branch transmission line and an equivalent phase shift of the first switch and the second value is smaller than or equal to the second preset error threshold, and the second value is an integer multiple of a first carrier wave length.

6.  The multi-port connection circuit according to any one of claims 1 to 5, wherein the first end of the first switch is further connected to a first end of a first phase shift network, and the first end of the second switch is further connected to a first end of a second phase shift network;

when the first end of the first switch and the second end of the first switch are connected and the first end of the second switch and the second end of the second switch are connected, a second end of the first phase shift network and the second end of the first common transmission line are in an impedance matching state in the first frequency band, and the first phase shift network is used for suppressing a signal in the second frequency band; and

a second end of the second phase shift network and the second end of the first common transmission line are in an impedance matching state in the second frequency band, and the second phase shift network is used for suppressing a signal in the first frequency band.

7. The multi-port connection circuit according to claim 1, wherein the first switch is a multi-pole multi-throw switch, a third end of the first switch and the first end of the first switch are two ends that are capable of being connected, and the third end of the first switch and a fourth end of the first switch are two ends that are capable of being connected; and/or, the second switch is a multi-pole multi-throw switch, a third end of the second switch and the first end of the second switch are two ends that are capable of being connected, and the third end of the second switch and a fourth end of the second switch are two ends that are capable of being connected.

8. The multi-port connection circuit according to claim 7, further comprising: a third branch transmission line, a fourth branch transmission line, and a second common transmission line, wherein

the third end of the first switch is connected to a first end of the third branch transmission line, and the third end of the second switch is connected to a first end of the fourth branch transmission line; and

a second end of the third branch transmission line and a second end of the fourth branch transmission line are both directly connected to a first end of the second common transmission line.

9. The multi-port connection circuit according to claim 8, wherein

when the third end of the first switch and the fourth end of the first switch are connected and the third end of the second switch is disconnected, the fourth end of the first switch and a second end of the second common transmission line are in an impedance matching state in a third frequency band, and the fourth end of the second switch is in a high-impedance state in a fourth frequency band; and

when the third end of the first switch is disconnected and the third end of the second switch and the fourth end of the second switch are connected, the fourth end of the first switch is in a high-impedance state in the fourth frequency band, and the fourth end of the second switch and the second end of the second common transmission line are in an impedance matching state in the fourth frequency band.

10. The multi-port connection circuit according to claim 9, wherein a frequency of the fourth frequency band is higher than that of the third frequency band; and

when the third end of the first switch is disconnected and the third end of the second switch and the fourth end of the second switch are connected, a difference between a sum of an electrical length of the third branch transmission line, an electrical length of the fourth branch transmission line, and an equivalent phase shift of the first switch and a third value is smaller than or equal to a third preset error threshold, and the third value is a sum of an integer multiple of a second carrier wave length corresponding to the fourth frequency band and a quarter of the second carrier wave length; or,

a difference between two times of an electrical length of the third branch transmission line and a fourth value is smaller than or equal to a fourth preset error threshold, a difference between two times of a sum of an electrical length of the fourth branch transmission line and an equivalent phase shift of the first switch and the fourth value is smaller than or equal to the fourth preset error threshold, and the fourth value is an integer multiple of a second carrier wave length.

11. The multi-port connection circuit according to claim 8, wherein

a first transmission path of the fifth frequency band comprises: the first end of the first switch, the second end of the first switch, the first branch transmission line, and the first common transmission line; and

a second transmission path of the fifth frequency band comprises: the first end of the first switch, the third end of the first switch, the third branch transmission line, and the second common transmission line.

**12.** The multi-port connection circuit according to claim 8 or 11, wherein

a first reception path of the fifth frequency band comprises: the first common transmission line, the second branch transmission line, the second end of the second switch, and the first end of the second switch; and
a second reception path of the fifth frequency band comprises: the second common transmission line, the fourth branch transmission line, the third end of the second switch, and the fourth end of the second switch.

**13.** The multi-port connection circuit according to claim 11 or 12, further comprising: a third switch, a fourth switch, a fifth branch transmission line, a sixth branch transmission line, a seventh branch transmission line, an eighth branch transmission line, a third common transmission line, and a fourth common transmission line, wherein

a first end of the third switch and a second end of the third switch are two ends that are capable of being connected, and a first end of the fourth switch and a second end of the fourth switch are two ends that are capable of being connected;
the second end of the third switch is connected to a first end of the fifth branch transmission line, and the second end of the fourth switch is connected to a first end of the sixth branch transmission line;
a second end of the fifth branch transmission line and a second end of the sixth branch transmission line are both directly connected to a first end of the third common transmission line;
a third end of the third switch and a fourth end of the third switch are two ends that are capable of being connected, and a third end of the fourth switch and a fourth end of the fourth switch are two ends that are capable of being connected;
the third end of the third switch is connected to a first end of the seventh branch transmission line, and the third end of the fourth switch is connected to a first end of the eighth branch transmission line; and
a second end of the seventh branch transmission line and a second end of the eighth branch transmission line are both directly connected to a first end of the fourth common transmission line.

**14.** The multi-port connection circuit according to claim 13, wherein the first end of the first switch and a fifth end of the first switch are two ends that are capable of being connected, and the fifth end of the first switch is connected to the first end of the third switch;

a third transmission path of the fifth frequency band comprises: the first end of the first switch, the fifth end of the first switch, the first end of the third switch, the second end of the third switch, the fifth branch transmission line, and the third common transmission line; and
a fourth transmission path of the fifth frequency band comprises: the first end of the first switch, the fifth end of the first switch, the first end of the third switch, the third end of the third switch, the seventh branch transmission line, and the fourth common transmission line.

**15.** The multi-port connection circuit according to claim 14, wherein

a third reception path of the fifth frequency band comprises: the third common transmission line, the sixth branch transmission line, the second end of the fourth switch, and the first end of the fourth switch; and
a fourth reception path of the fifth frequency band comprises: the fourth common transmission line, the eighth branch transmission line, the third end of the fourth switch, and the fourth end of the fourth switch.

**16.** The multi-port connection circuit according to claim 14, wherein

a third reception path of the fifth frequency band comprises: the third common transmission line, the fifth branch transmission line, the second end of the third switch, and a fifth end of the third switch; and
a fourth reception path of the fifth frequency band comprises: the fourth common transmission line, the seventh branch transmission line, the third end of the third switch, and the fourth end of the third switch.

**17.** A radio frequency front-end module, comprising one or more multi-port connection circuits according to claims 1 to 16.

**18.** An electronic device, comprising one or more multi-port connection circuits according to claims 1 to 16, or comprising the radio frequency front-end module according to claim 17.

Terminal device 100

Antenna 1

Antenna 2

| Mobile communication module<br>2G/3G/4G/5G<br>[150] | Wireless communication module<br>BT/WLAN/GNSS/NFC/IR/FM<br>[160] |

Speaker [170A]

Phone receiver
[170B]

Audio
module

[170]

Microphone
[170C]

Headset jack
[170D]

Display screens 1 to N
[194]

Cameras 1 to N [193]

Indicator [192]

Motor [191]

Key [190]

Internal memory [121]

SIM card interfaces 1 to N
[195]

External memory interface
[120]

Processor

[110]

Sensor module [180]

Pressure sensor
[180A]

Gyroscope sensor
[180B]

Barometric pressure
sensor [180C]

Magnetic sensor
[180D]

Acceleration sensor
[180E]

Distance sensor
[180F]

Optical proximity
sensor [180G]

Fingerprint sensor
[180H]

Temperature sensor
[180J]

Touch sensor
[180K]

Ambient light sensor
[180L]

Bone conduction
sensor [180M]

USB interface [130]

Charging input

Charging
management
module
[140]

Power
management
module [141]

Battery [142]

FIG. 1

FIG. 2

FIG. 3

FIG. 4

Port 2
(50 ohm)

Port 1
(50 ohm)

Port 3
(High-impedance
state)

FIG. 5

First switch

Port 2

1

2

First common
transmission line

Port 1

FIG. 6

First switch

First branch
transmission line

Port 2

1

2

1

First common
transmission line

Second switch

Port 3

2   1
2
2

Port 1

2

1

Second branch
transmission line

FIG. 7

First switch

Port 2

First branch
transmission line

First common
transmission line

1

Second switch

Port 1

2

2

2

1

Port 3

1

2 1

Second branch
transmission line

FIG. 8

First phase
shift network

First switch

First branch
transmission line

Port 2

2 1

1

2

First common
transmission line

1

Second switch

2
2

1

Port 1

2

Port 3

2 1

1

2 1

Second branch
transmission line

Second phase
shift network

FIG. 9

First switch

Port 2

First branch
transmission line

First common
transmission line

Second switch

Port 3

Port 1

Second branch
transmission line

FIG. 10

First switch

Third branch
transmission line

Second common
transmission line

Port 2

Port 5

First branch
transmission line

Second switch

Port 4

Second branch
transmission line

Port 3

Port 1

First common
transmission line

Port 6

Fourth branch
transmission line

FIG. 11

Dual-pole
dual-throw switch
(First switch)

Port 2

High-frequency
signal-single channel

High-frequency signal-CA/DC

ANT1            ANT1

First branch
transmission line

First
common
transmission
line

Dual-pole
four-throw
switch-2

Dual-pole
four-throw switch-1
(Second switch)

Port 3

Middle-frequency
signal-CA/DC

Middle-frequency
signal-single channel

Second branch
transmission line

Middle-
frequency
signal-diversity

Port 1

a

Dual-pole
four-throw switch
(First switch)

n41-MIMO-RX

B1-B3-TRX

Middle-frequency
signal-diversity

Third branch
transmission line

ANT1            ANT2

First common
transmission line

Second
common
transmission
line

First branch
transmission
line

Dual-pole
four-throw switch
(Second switch)

B40-TRX

B34-B39-RX

B34-B39-TX

GSM-HB-TX

Second
branch
transmission
line

Fourth branch
transmission line

b

FIG. 12

FIG. 13

⌐⌐ : Filter

⌐v⌐ : Notch filter

/\/\ : Combiner (duplexer)

/\/\v/\/\ : Quadruplexer

⊟ : Coupler

**n41_B1_B3_TAS**

n41_TRX — n41_TX

PD detection

B1_B3_MPRX

B1_B3_MDRX

B39_MDRX

Three-pole three-throw switch (First switch-1)

1805 MHz-2690 MHz

1805 MHz-2690 MHz

Dual-pole four-throw switch (Second switch-1)

n41_PRX

n41_MDRX

B39_MPRX

B1_B3_TAS

1710 MHz-2690 MHz

1710 MHz-2690 MHz

ANT3  ANT4

GSM_HB_TX

B7_TX
B7_PRX
B2_TX
B2_PRX
B40_TRX

PD detection

Dual-pole four-throw switch (First switch-2)

1710 MHz-3800MHz

MHB_DIV_LDiFEM

n41_MPRX

1710 MHz-2690MHz

B3_TX
B3_PRX
B1_TX
B1_PRX
B34_B39_TX

B39_PRX
B34_PRX

B34_B39_RX

Three-pole three-throw switch (Second switch-2)

1710 MHz-2170MHz

1710 MHz-2170MHz

ANT1  ANT2

FIG. 14

ANT3    ANT4

n41_B1_B3_TAS

Three-pole
three-throw switch
(First switch-1)

Third branch
transmission
line

1   5

3   1
2
2

4   1
First branch
transmission line   2

Dual-pole
four-throw switch
(Second switch-1)   Second branch
transmission line

2

1

First common
transmission
line

2
2   1

Second common
transmission line

B1_B3_TAS

4   2   1

1

3   1

Fourth branch
transmission line

Dual-pole
four-throw switch
(First switch-2)

Seventh branch
transmission line

ANT1

3

1
5   2
4

2

Fifth branch
transmission line

ANT2

2   1
2

Three-pole
three-throw switch
(Second switch-2)   Sixth branch
transmission line

Third common
transmission
line

2
2   1

Fourth common
transmission line

1   2   1

3
1
4

Eighth branch
transmission line

FIG. 15

FIG. 16

ANT3 ANT4

Three-pole three-throw
switch
(First switch-1)

n41_TX_TAS2

n41_TX_
TAS2

Dual-pole four-throw switch
(Second switch-1)

ANT1

ANT2

Dual-pole four-throw switch
(First switch-2)

Three-pole three-throw
switch
(Second switch-2)

FIG. 17

FIG. 18

n41_TX_TAS4

Three-pole three-throw
switch
(First switch-1)

n41_TX_TAS4

Dual-pole four-throw switch
(Second switch-1)

ANT3

ANT4

Dual-pole four-throw switch
(First switch-2)

ANT1

ANT2

n41_TX_TAS4

Three-pole three-throw switch
(Second switch-2)

FIG. 19

ANT3    ANT4

Three-pole three-throw switch
(First switch-1)

n41_RX1

n41_RX1

Dual-pole
four-throw switch
(Second switch-1)

n41_RX2

n41_RX1

n41_RX1

n41_RX1

ANT1

ANT2

Dual-pole four-throw
switch
(First switch-2)

n41_RX4

n41_RX3

n41_RX4

n41_RX3

n41_RX3

n41_RX4

Three-pole three-throw
switch
(Second switch-2)

FIG. 20

ANT3    ANT4

Three-pole three-throw
switch
(First switch-1)

Dual-pole four-throw
switch
(Second switch-1)

Dual-pole four-throw
switch
(First switch-2)

ANT1

B1/B3_TX_TAS1

ANT2

B1/B3_TX_TAS1

B1/
B3_TX_TAS1

Three-pole three-throw
switch
(Second switch-2)

FIG. 21

FIG. 22

ANT3          ANT4

Three-pole
three-throw switch
(First switch-1)

B1/
B3_TX_TAS3

B1/B3_TX_TAS3

B1/B3_TX_TAS3

Dual-pole four-throw switch
(Second switch-1)

ANT1

ANT2

Dual-pole four-throw switch
(First switch-2)

Three-pole
three-throw switch
(Second switch-2)

B1/
B3_TX_TAS3

B1/B3_TX_TAS3

FIG. 23

FIG. 24

ANT3  ANT4

Three-pole
three-throw switch
(First switch-1)

B1/B3_RX3

B1/B3_RX3
B1/B3_RX4

B1/B3_RX4

B1/
B3_RX3

B1/B3_RX4

Dual-pole
four-throw switch
(Second switch-1)

ANT1

Dual-pole four-throw
switch
(First switch-2)

B1/B3_RX2

ANT2

B1/B3_RX2

B1/B3_RX1

B1/B3_RX2

Three-pole
three-throw switch
(Second switch-2)

B1/
B3_RX1

B1/B3_RX1

B1/B3_RX1

FIG. 25

Three-pole three-throw
switch
(First switch)

B1_B3_MPRX

B39_MPRX       1805 MHz-2690 MHz

B1_B3_MDRX      1805 MHz-2690 MHz

ANT3

ANT4

Dual-pole four-throw
switch
(Second switch)

B39_MDRX

n41_MDRX     1710 MHz-
             2690MHz

n41_TX       1710 MHz-2690MHz

B1_B3_TAS

ANT1      ANT2

Three-pole
three-throw switch

n78

FIG. 26

First switch

Port 2

1

3
2 1

Second switch

Port 3

Port 1

a

First switch

Port 5
(Corresponding
to port 2)

1

2

Port 4
(Corresponding
to port 1)

b

FIG. 27

FIG. 28

## INTERNATIONAL SEARCH REPORT

| International application No. |
| --- |
| **PCT/CN2024/081551** |

**A. CLASSIFICATION OF SUBJECT MATTER**

H04B1/401(2015.01)i

According to International Patent Classification (IPC) or to both national classification and IPC

**B. FIELDS SEARCHED**

Minimum documentation searched (classification system followed by classification symbols)

IPC: H04B H04L H04W

Documentation searched other than minimum documentation to the extent that such documents are included in the fields searched

Electronic data base consulted during the international search (name of data base and, where practicable, search terms used)

DWPI, CNTXT, ENTXT, ENTXTC, CNKI: 多, 频, 阻抗匹配, 公共, 分支, 传输线, 开关, 断, 波长, 相位, 相移, RF, multi, frequency, band, impedance, match , switch, shift, on, off, SP?T, DP?T, MP?T, NP?T, line, branch, common, length, phase, shift

**C. DOCUMENTS CONSIDERED TO BE RELEVANT**

| Category* | Citation of document, with indication, where appropriate, of the relevant passages | Relevant to claim No. |
| --- | --- | --- |
| X | US 11563410 B1 (ROCKWELL COLLINS, INC.) 24 January 2023 (2023-01-24) description, column 5 line 60-column 18 line 64, and figures 4 and 5 | 1-4, 6-9, 11-18 |
| A | CN 110504977 A (GOERTEK TECHNOLOGY CO., LTD.) 26 November 2019 (2019-11-26) entire document | 1-18 |
| A | CN 113285697 A (UNIVERSITY OF ELECTRONIC SCIENCE AND TECHNOLOGY OF CHINA) 20 August 2021 (2021-08-20) entire document | 1-18 |
| A | US 2022376722 A1 (IGNION, S. L.) 24 November 2022 (2022-11-24) entire document | 1-18 |
| A | CN 108476028 A (SKYWORKS SOLUTIONS, INC.) 31 August 2018 (2018-08-31) entire document | 1-18 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **12 June 2024** | **17 June 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| US | 11563410 | B1 | 24 January 2023 | None | | | |
| CN | 110504977 | A | 26 November 2019 | None | | | |
| CN | 113285697 | A | 20 August 2021 | None | | | |
| US | 2022376722 | A1 | 24 November 2022 | EP | 4092915 | A1 | 23 November 2022 |
| CN | 108476028 | A | 31 August 2018 | KR | 20180073696 | A | 02 July 2018 |
| | | | | KR | 102594543 | B1 | 26 October 2023 |
| | | | | HK | 1256799 | A1 | 04 October 2019 |
| | | | | WO | 2017083596 | A1 | 18 May 2017 |
| | | | | US | 2017141759 | A1 | 18 May 2017 |
| | | | | US | 10256794 | B2 | 09 April 2019 |
| | | | | TW | 201722070 | A | 16 June 2017 |
| | | | | TWI | 699968 | B | 21 July 2020 |
| | | | | US | 2019207586 | A1 | 04 July 2019 |
| | | | | US | 10985733 | B2 | 20 April 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310724481X